# EUROPEAN PATENT SPECIFICATION

(11) **EP 4 398 319 B1**
(45) Date of publication and mention of the grant of the patent: **25.11.2026**
(21) Application number: 22864806.9
(22) Date of filing: 22.04.2022
(51) Int. Cl.: H10H 20/819, H10H 20/831, H10H 20/01, H10H 29/30

(54) **LIGHT-EMITTING DEVICE, DISPLAY DEVICE COMPRISING SAME, AND METHOD FOR MANUFACTURING LIGHT-EMITTING DEVICE**
LICHTEMITTIERENDE VORRICHTUNG, ANZEIGEVORRICHTUNG DAMIT UND VERFAHREN ZUR HERSTELLUNG DER LICHTEMITTIERENDEN VORRICHTUNG
DISPOSITIF ÉLECTROLUMINESCENT, DISPOSITIF D'AFFICHAGE LE COMPRENANT, ET PROCÉDÉ DE FABRICATION D'UN DISPOSITIF D'ÉLECTROLUMINESCENT

(30) Priority: 30.08.2021 KR 20210115118
(43) Date of publication of application: 10.07.2024
(73) Proprietor: Samsung Display Co., Ltd., Yongin-si, Gyeonggi-do 17113 (KR)
(72) Inventor: KIM, Hyung Seok, Yongin-si, Gyeonggi-do 17113 (KR); KIM, Si Sung, Yongin-si, Gyeonggi-do 17113 (KR); LEE, Jong Jin, Yongin-si, Gyeonggi-do 17113 (KR); LEE, Dong Eon, Yongin-si, Gyeonggi-do 17113 (KR)
(74) Representative: Marks & Clerk LLP
(86) International application number: PCT/KR2022/005785
(87) International publication number: WO 2023/033297

(56) References cited:
- WO-A1-2021/049725
- WO-A1-2021/054551
- WO-A1-2021/118181
- WO-A1-2022/065557
- KR-A- 20150 113 288
- KR-A- 20160 087 550
- KR-A- 20210 003 991
- KR-A- 20210 008 206
- US-A1- 2020 176 637
- US-B2- 9 329 433

## Description

### Technical Field

**The** present invention relates to a light emitting element, a display device including the same, and a manufacturing method of the light emitting element.

### Background Art

Recently, interest in an information display is increasing. Accordingly, research and development on a display device are continuously being conducted.

US 2020/176637 A1, WO 2021/118181 A1, WO 2021/054551 A1, WO 2021/049725 A1 and KR 20210008206 A disclose a light emitting element including a first semiconductor layer, an emission layer, a second semiconductor layer, an electrode layer on the second semiconductor layer, and an insulating layer on the side surfaces of the first semiconductor layer, the emission layer, the second semiconductor layer, and the electrode layer, and a display device comprising such a light emitting element.

### Detailed Description of Invention

### Technical Problem

The present invention has been made in an effort to provide a light emitting element that may prevent short circuit defects, a display device including the same, and a manufacturing method of the light emitting element.

The objects of the present invention are not limited to the object mentioned above, and other technical objects that are not mentioned may be clearly understood to a person of an ordinary skill in the art using the following description.

### Technical Solution

The present invention provides a light emitting element according to claim 1.

The insulating film may completely surround the side surfaces of the emission layer and the second semiconductor layer.

The electrode layer may directly electrically contact with the second semiconductor layer on the first surface.

The insulating film may surround a portion of the side surface of the electrode layer disposed around the first surface of the electrode layer, and may expose the second surface of the electrode layer and the remaining portion of the side surface of the electrode layer.

The insulating film may expose a lower surface of the first semiconductor layer.

The insulating film may have a uniform thickness at the end portion of the light emitting element.

The insulating film may have a surface profile corresponding to a shape of each side surface of the first semiconductor layer, the emission layer, and the second semiconductor layer in a portion surrounding the first semiconductor layer, the emission layer, and the second semiconductor layer.

The insulating film may have a surface profile corresponding to a shape of the side surface of the electrode layer at the end portion of the light emitting element.

The insulating film may have a thickness that is gradually changed at the end portion of the light emitting element.

The insulating film may have a thickness that increases as it approaches the emission layer at the end portion of the light emitting element.

The first semiconductor layer may include a first portion adjacent to the emission layer and a second portion excluding the first portion, and a width of the first portion may be greater than a width of the second portion.

A thickness of a portion surrounding the second portion of the first semiconductor layer may be greater than a width of a portion surrounding the first portion of the first semiconductor layer in the insulating film.

The insulating film may have a thickness of 10 nm or more at a portion corresponding to the first surface of the electrode layer.

The present invention further provides a display device according to claim 11.

The insulating film may completely surround the side surfaces of the emission layer and the second semiconductor layer.

The electrode layer may directly electrically contact the second semiconductor layer on the first surface. The insulating film may surround a portion of the side surface of the electrode layer disposed around the first surface of the electrode layer, and may expose the second surface of the electrode layer and the remaining portion of the side surface of the electrode layer.

The present invention further provides a manufacturing method of a light emitting element according to claim 13.

The mask layer may be formed with a thickness of about 2 µm or more.

The forming of the mask layer may include: forming a first mask layer with a thickness of about 2 µm or more on the electrode layer; and forming a second mask layer with a thickness of about 160 nm or more on the first mask layer by using a material different from a material of the first mask layer.

The forming of the insulating film may include: entirely forming the insulating film on one surface of the substrate including the stacked body; and etching the insulating film so that an upper surface of the electrode layer is exposed.

Particularities of other embodiments are included in the detailed description and drawings.

### Advantageous Effects

According to the embodiments of the present invention, an insulating film having a sufficient thickness may be formed even around the electrode layer. For example, the insulating film may be formed to have a thickness sufficient to include an overetching margin that may occur in a subsequent process around the electrode layer and the second semiconductor layer adjacent to the electrode layer.

Accordingly, even if the insulating film of the light emitting element is partially etched in a pixel process or the like, the insulating film may remain on a surface of the light emitting element while stably surrounding the second semiconductor layer. Accordingly, it is possible to prevent a short circuit defect through the light emitting element.

Effects of embodiments of the present invention are not limited by what is illustrated in the above, and more various effects are included in the present specification.

### Description of Drawings

FIG. 1 illustrates a schematic perspective view of a light emitting element according to an embodiment of the present invention.
FIG. 2 illustrates a cross-sectional view of a light emitting element according to an embodiment of the present invention.
FIG. 3 to FIG. 7 respectively illustrate a cross-sectional view of a light emitting element according to an embodiment of the present invention.
FIG. 8 to FIG. 17 illustrate cross-sectional views of a manufacturing method of a light emitting element according to an embodiment of the present invention.
FIG. 18 illustrates a top plan view of a display device according to an embodiment of the present invention.
FIG. 19 and FIG. 20 respectively illustrate a circuit diagram of a pixel according to an embodiment of the present invention.
FIG. 21 illustrates a top plan view of a pixel according to an embodiment of the present invention.
FIG. 22 illustrates a cross-sectional view of a display device according to an embodiment of the present invention.
FIG. 23 illustrates an enlarged cross-sectional view of one area of the pixel shown in FIG. 22.
FIG. 24 to FIG. 26 illustrate cross-sectional views of a manufacturing method of a pixel according to an embodiment of the present invention.

### Modes of the Invention

Since the present invention may be variously modified and have various forms, embodiments will be illustrated and described in detail in the following. In the description below, singular forms are to include plural forms unless the context clearly indicates only the singular.

The present invention is not limited to the embodiments disclosed hereinafter and may be implemented in various forms within the scope of the present invention as defined by the claims. In addition, each embodiment disclosed below may be implemented alone, or may be implemented in combination with at least one another embodiment.

Some of the elements not directly related to the features of the present invention may be omitted from the drawing in order to clearly illustrate the present invention. For the same or similar elements throughout drawing, the same reference numerals and symbols are to be given as much as possible, and duplicate descriptions will be omitted.

In describing the embodiments of the present invention, the term "connection (or coupling)" may comprehensively mean a physical and/or electrical connection (or coupling). In addition, it may comprehensively mean a direct connection (or coupling) and an indirect connection (or coupling), and may comprehensively mean an integral connection (or coupling) and a non-integral connection (or coupling).

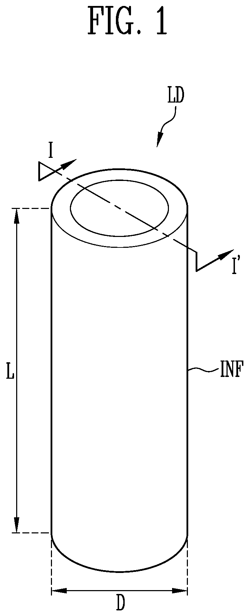

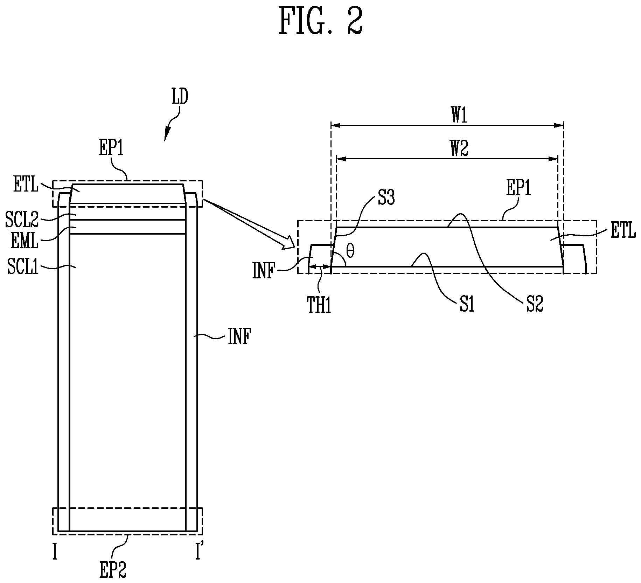

FIG. 1 illustrates a schematic perspective view of a light emitting element LD according to an embodiment of the present invention. FIG. 2 illustrates a cross-sectional view of a light emitting element LD according to an embodiment of the present invention. For example, FIG. 2 shows an embodiment of a cross-section of the light emitting element LD corresponding to line I-I' in FIG. 1.

Referring to FIG. 1 and FIG. 2, the light emitting element LD may include a first semiconductor layer SCL1, an emission layer EML, a second semiconductor layer SCL2, and an electrode layer ETL sequentially disposed and/or stacked along one direction (for example, length direction or thickness direction). In the embodiment, the light emitting element LD may further include at least one other semiconductor layer (for example, at least one other semiconductor layer disposed above and/or below the light emitting layer EML) and/or at least one electrode layer (for example, an electrode layer disposed around the first semiconductor layer SCL1).

In the embodiment, the light emitting element LD may be provided in a rod shape. In describing the embodiment of the present invention, the rod shape includes a rod-like shape or bar-like shape of various types including a circular pillar shape or a polygonal pillar shape, and a shape of a cross-section thereof is not particularly limited. In the embodiment, a length L of the light emitting element LD may be larger than a diameter D thereof (or a width of a lateral cross-section thereof).

The light emitting element LD may include a first end portion EP1 and a second end portion EP2 that face each other. For example, the light emitting element LD may include the first end portion EP1 and the second end portion EP2 at both ends of a length direction (or a thickness direction) thereof. The first end portion EP1 of the light emitting element LD may include a first base surface (for example, an upper surface) of the light emitting element LD and/or a peripheral area thereof. The second end portion EP2 of the light emitting element LD may include a second base surface (for example, a lower surface) of the light emitting element LD and/or a peripheral area thereof.

In the embodiment, the first semiconductor layer SCL1, the emission layer EML, the second semiconductor layer SCL2, and the electrode layer ETL may be sequentially disposed in a direction from the second end portion EP2 to the first end portion EP1 of the light emitting element LD. For example, the electrode layer ETL may be disposed on the first end portion EP1 of the light emitting element LD, and the first semiconductor layer SCL1 (or another electrode layer adjacent to the first semiconductor layer SCL1 and electrically connected to the first semiconductor layer SCL1) may be disposed on the second end portion EP2 of the light emitting element LD.

The light emitting element LD may further include an insulating film INF covering side surfaces of the first semiconductor layer SCL1, the emission layer EML, and the second semiconductor layer SCL2. The insulating film INF may at least partially cover a side surface of the electrode layer ETL. For example, the insulating film INF may surround a portion of the electrode layer ETL at the first end portion EP1. For example, the insulating film INF may surround a portion (for example, a lower layer) of a side surface S3 of the electrode layer ETL, and it may not surround the remaining portion (for example, an upper layer) of the side surface S3 of the electrode layer ETL.

The first semiconductor layer SCL1 may include a first conductive type of semiconductor layer including a first conductive type of dopant. For example, the first semiconductor layer SCL1 may be an N-type of semiconductor layer including an N-type of dopant.

In the embodiment, the first semiconductor layer SCL1 may include a nitride-based semiconductor material or a phosphide-based semiconductor material. For example, the first semiconductor layer SCL1 may include a nitride-based semiconductor material including at least one of GaN, AlGaN, InGaN, AlInGaN, AIN, and InN, or a phosphide-based semiconductor material including at least one of GaP, GaInP, AlGaP, AlGaInP, AlP, and InP. In the embodiment, the first semiconductor layer SCL1 may include an N-type of dopant such as Si, Ge, Sn, or the like. The material included in the first semiconductor layer SCL1 is not limited thereto, and in addition to this, various materials may be used to form the first semiconductor layer SCL1.

The emission layer EML (also referred to as an "active layer") may be disposed on the first semiconductor layer SCL1. The emission layer EML may include a single or multiple quantum well (QW) structure. When a voltage of a threshold voltage or more is applied to both ends of the light emitting element LD, light may be emitted while electron-hole pairs are recombined in the emission layer EML.

In the embodiment, the emission layer EML may emit light of a visible ray wavelength band, for example, light of a wavelength band of about 400 nm to 900 nm. For example, the emission layer EML may emit blue light having a wavelength ranging from about 450 nm to 480 nm, green light having a wavelength ranging from about 480 nm to 560 nm, or red light having a wavelength ranging from about 620 nm to 750 nm. In addition to this, the color and/or wavelength band of the light generated by the emission layer EML may be changed.

In the embodiment, the emission layer EML may include a nitride-based semiconductor material or a phosphide-based semiconductor material. For example, the emission layer EML may include a nitride-based semiconductor material including at least one of GaN, AlGaN, InGaN, InGaAlN, AIN, InN, and AlInN, or a phosphide-based semiconductor material including at least one of GaP, GaInP, AlGaP, AlGaInP, AlP, and InP. The material included in the emission layer EML is not limited thereto, and in addition to this, various materials may be used to form the emission layer EML.

In the embodiment, the emission layer EML may include an element involved in a color (or wavelength band) of light, and a color of light generated in the emission layer EML may be controlled by adjusting a content and/or composition ratio of the element. For example, the emission layer EML may be formed to have a multi-layered structure in which a GaN layer and an InGaN layer are alternately and/or repeatedly stacked with each other, and it may emit light of a specific color according to a content and/or composition ratio of indium (In) included in the InGaN layer. Accordingly, the light emitting element LD of a desired color may be manufactured by adjusting the content and/or composition ratio of indium (In) included in the emission layer EML.

The second semiconductor layer SCL2 may be disposed on the emission layer EML. The second semiconductor layer SCL2 may include a second conductive type of semiconductor layer including a second conductive type of dopant. For example, the second semiconductor layer SCL2 may be a P-type of semiconductor layer including a P-type of dopant.

In the embodiment, the second semiconductor layer SCL2 may include a nitride-based semiconductor material or a phosphide-based semiconductor material. For example, the second semiconductor layer SCL2 may include a nitride-based semiconductor material including at least one of GaN, AlGaN, InGaN, AlInGaN, AIN, and InN, or a phosphide-based semiconductor material including at least one of GaP, GaInP, AlGaP, AlGaInP, AlP, and InP. In the embodiment, the second semiconductor layer SCL2 may include a P-type of dopant such as Mg. The material included in the second semiconductor layer SCL2 is not limited thereto, and in addition to this, various materials may be used to form the second semiconductor layer SCL2.

In the embodiment, the first semiconductor layer SCL1 and the second semiconductor layer SCL2 may include the same semiconductor material, but may include dopants of different conductive types. In another embodiment, the first semiconductor layer SCL1 and the second semiconductor layer SCL2 may include different semiconductor materials, and may include dopants of different conductive types.

In the embodiment, the first semiconductor layer SCL1 and the second semiconductor layer SCL2 may have different lengths (or thicknesses) in the length direction of the light emitting element LD. For example, the first semiconductor layer SCL1 may have a longer length (or thicker thickness) than that of the second semiconductor layer SCL2 along the length direction of the light emitting element LD. Accordingly, the emission layer EML may be positioned closer to the first end portion EP1 (for example, the P-type of end portion) than the second end portion EP2 (for example, the N-type of end portion).

The electrode layer ETL may be disposed on the second semiconductor layer SCL2. For example, the electrode layer ETL may be directly formed on the second semiconductor layer SCL2 so as to be in contact with the second semiconductor layer SCL2 on a first surface S1. In accordance with the present invention, the electrode layer ETL and the second semiconductor layer SCL2 have **the** same width width may have a surface area corresponding to each other at a bonding surface. For example, the electrode layer ETL and the second semiconductor layer SCL2 have the same width at the bonding surface, and may have substantially the same cross-section.

The electrode layer ETL may protect the second semiconductor layer SCL2, and may configure an electrode for easily connecting the second semiconductor layer SCL2 to a predetermined electrode or wire. For example, the electrode layer ETL may be an ohmic contact electrode or a Schottky contact electrode.

In the embodiment, the electrode layer ETL may include metal or a metal oxide. For example, the electrode layer ETL may be formed by singly using or mixing a metal such as chromium (Cr), titanium (Ti), aluminium (Al), gold (Au), nickel (Ni), or copper (Cu), and an oxide or alloy thereof; and a transparent conductive material such as an indium tin oxide (ITO), an indium zinc oxide (IZO), an indium tin zinc oxide (ITZO), a zinc oxide (ZnO), or an indium oxide (In₂O₃). The material configuring the electrode layer ETL is not limited thereto, and in addition to this, various conductive materials may be used to form the electrode layer ETL.

In the embodiment, the electrode layer ETL may be substantially transparent. Accordingly, light generated by the light emitting element LD may pass through the electrode layer ETL to be emitted from the first end portion EP1 of the light emitting element LD.

The electrode layer ETL may include a first surface S1 (for example, a lower surface of the electrode layer ETL) and a second surface S2 (for example, an upper surface of the electrode layer ETL) facing each other. In addition, the electrode layer ETL may include a side surface S3 (also referred to as a "third surface" of the electrode layer ETL) connecting the first surface S1 and the second surface S2.

In the embodiment, the first surface S1 and the second surface S2 of the electrode layer ETL may have different widths and/or areas. For example, the second surface S2 of the electrode layer ETL may have a smaller (for example, narrower) width and/or area than the first surface S1 of the electrode layer ETL. For example, the first surface S1 of the electrode layer ETL may have a first width W1, the second surface S2 of the electrode layer ETL may have a second width W2 smaller than the first width W1 and an area smaller than the first surface S1.

In the embodiment, the side surface S3 of the electrode layer ETL may have a slope inclined by an angle (θ) of a predetermined range with respect to the first surface S1 (or the bottom surface of the light emitting element LD) of the electrode layer ETL. For example, the side surface S3 of the electrode layer ETL may have a slope corresponding to an angle (θ) of about 75° to 90° with respect to the first surface S1 of the electrode layer ETL. In the case that the side surface S3 of the electrode layer ETL has a slope corresponding to an angle (θ) of about 75° or more, the insulating layer INF with a sufficient thickness may be formed even at the first end EP1 and its periphery (for example, peripheries of the electrode layer ETL and the second semiconductor layer SCL2).

In the embodiment, the side surface S3 of the electrode layer ETL may have a steep slope corresponding to an angular range of about 80° or more, for example, 80° or more and less than 90° with respect to the first side S1 of the electrode layer ETL, and it may be substantially perpendicular to the first surface S1 of the electrode layer ETL. In this case, even if a deviation according to a process margin is considered, the insulating film INF may be formed to have a sufficient thickness at and around the first end portion EP1. Accordingly, even if over-etching occurs in a subsequent process, the insulating film INF may completely surround the second semiconductor layer SCL2 and remain around the second semiconductor layer SCL2.

In the embodiment, the electrode layer ETL may have a small thickness of about 100 nm to 200 nm, and in addition to this, the thickness of the electrode layer ETL may be variously changed according to embodiments. In the case that the electrode layer ETL has a relatively small thickness (for example, the exemplified thickness of 100 nm to 200 nm), reduction in light emitting efficiency of the light emitting element LD due to the provision of the electrode layer ETL may be prevented or minimized, and the electrode layer ETL may be more readily formed in a desired shape. For example, in the case that the electrode layer ETL has a relatively small thickness, the electrode layer ETL may be easily patterned so that the side surface S3 of the electrode layer ETL has a slope corresponding to an angle (θ) of about 75° or more (for example, 80° or more).

The insulating film INF may be provided on a surface of the light emitting element LD to surround side surfaces of the first semiconductor layer SCL1, the emission layer EML, the second semiconductor layer SCL2, and the electrode layer ETL.

In the case that the insulating film INF is provided on the surface of the light emitting element LD, a short circuit defect through the light emitting element LD may be prevented. Therefore, electrical stability of the light emitting element LD may be secured. In addition, in the case that the insulating film INF is provided on the surface of the light emitting element LD, it is possible to improve life-span and efficiency thereof by minimizing surface defects of the light emitting element LD.

The insulating film INF may include a transparent insulating material. Accordingly, light generated in the emission layer EML may transmit through the insulating film INF to be emitted to the outside of the light emitting element LD. For example, the insulating film INF may include at least one insulating material of a silicon oxide (SiOₓ) (for example, SiO₂), a silicon nitride (SiNₓ) (for example, Si₃N₄), an aluminium oxide (AlₓO_{y}) (for example, Al₂O₃), a titanium oxide (TiₓO_{y}) (for example, TiO₂), and a hafnium oxide (HfOₓ), or other insulating materials.

The insulating film INF may be configured as a single layer or multilayer. For example, the insulating film INF may be formed as a double film.

The insulating film INF may expose the electrode layer ETL and the first semiconductor layer SCL1 (or another electrode layer provided at the second end portion EP2 of the light emitting element LD) at the first end portion EP1 and the second end portion EP2 of the light emitting element LD, respectively. For example, the insulating film INF may not be provided on the second surface S2 of the electrode layer ETL, and accordingly, it may expose the second surface S2 of the electrode layer ETL in the first end portion EP1 of the light emitting element LD. Accordingly, driving power and/or a signal may be applied to the first end portion EP1 of the light emitting element LD by connecting the electrode layer ETL to at least one electrode, wire, and/or conductive pattern. In addition, the insulating film INF may not be provided on a lower surface of the first semiconductor layer SCL1 (for example, the bottom surface of the light emitting element LD), and accordingly, the bottom surface of the first semiconductor layer SCL1 may be exposed in the second end portion EP2 of the light emitting element LD. Accordingly, driving power and/or a signal may be applied to the second end portion EP2 of the light emitting element LD by connecting the first semiconductor layer SCL1 to at least one electrode, wire, and/or conductive pattern.

The insulating film INF may completely surround at least side surfaces of the emission layer EML and the second semiconductor layer SCL2. Accordingly, electrical stability of the light emitting element LD may be secured, and a short circuit defect through the light emitting element LD may be prevented.

In the embodiment, the insulating film INF may partially surround the side surface S3 of the electrode layer ETL. For example, the insulating film INF may surround a portion of the side surface S3 of the electrode layer ETL (for example, a lower portion of the side surface S3) positioned around the first surface S1 of the electrode layer ETL, and the second surface S2 of the electrode layer ETL and the remaining portion of the side surface S3 of the electrode layer ETL (for example, an upper portion of the side surface S3) positioned around the second surface S2 may be exposed. For example, in a process of removing the insulating film INF on the second surface S2 of the electrode layer ETL, the insulating film INF may also be removed on the upper portion of the side surface S3 of the electrode layer ETL positioned around the second surface S2.

In the embodiment, the insulating film INF may be formed with an overall uniform thickness. For example, the insulating film INF may have a uniform thickness (for example, a first thickness TH1) in the entire area including the first end portion EP1.

In the embodiment, the insulating film INF may have a surface profile corresponding to side shapes of the first semiconductor layer SCL1, the emission layer EML, the second semiconductor layer SCL2, and the electrode layer ETL. For example, the insulating film INF may have a surface profile corresponding to a shape of the side surface S3 of the electrode layer ETL at the first end portion EP1 surrounding the electrode layer ETL. For example, the insulating film INF may have a curved shape and/or a slope corresponding to the shape of the side surface of the electrode layer ETL at and/or around the first end portion EP1. In the remaining area thereof, the insulating layer INF may have a surface profile corresponding to the shape of the side surfaces of the first semiconductor layer SCL1, the emission layer EML, and the second semiconductor layer SCL2. For example, the insulating film INF, in a portion surrounding the first semiconductor layer SCL1, the emission layer EML, and the second semiconductor layer SCL2, may have surface profile corresponding respective side shapes of the first semiconductor layer SCL1, the emission layer EML, and the second semiconductor layer SCL2.

The thickness and/or surface profile of the insulating film INF may be varied according to embodiments. For example, the thickness and/or surface profile of the insulating film INF may be varied depending on a process method, process condition, and/or material applied to form the insulating film INF. In the embodiment, when the insulating film INF is formed by using an atomic layer deposition (ALD) process technology capable of forming a film having a high step coverage, the insulating film INF may have the surface profile corresponding to the side shapes (for example, following the side shapes) of the first semiconductor layer SCL1, the emission layer EML, the second semiconductor layer SCL2, and the electrode layer ETL, and may be formed with the overall uniform thickness.

In the case that the side surface S3 of the electrode layer ETL has a slope corresponding to an angle (θ) of about 75° or more (for example, about 80° to 90°), the insulating film INF may be formed with a thickness sufficient to stably surround the second semiconductor layer SCL2 in an area corresponding to the bonding surface of the emission layer EML and the second semiconductor layer SCL2. For example, the insulating film INF may have the first thickness TH1 of 10 nm or more in a portion corresponding to the first surface S1 of the electrode layer ETL.

In addition, in a lower portion of the area corresponding to the bonding surface of the emission layer EML and the second semiconductor layer SCL2 (for example, in an area surrounding the second semiconductor layer SCL2, the emission layer EML, and the first semiconductor layer SCL1), the insulating film INF may be formed with a thickness that is substantially the same as or larger than the first thickness TH1 in the area corresponding to the bonding surface of the emission layer EML and the second semiconductor layer SCL2. For example, the insulating film INF may have a thickness equal to or larger than the first thickness TH1 in the lower portion of the area corresponding to the bonding surface of the emission layer EML and the second semiconductor layer SCL2, and may completely surround at least side surfaces of the second semiconductor layer SCL2 and the emission layer EML.

In addition, the insulating film INF, even when it is etched by a partial thickness around the second semiconductor layer SCL2 and/or the emission layer EML by over-etching that may occur in a process of etching the insulating film INF in order to expose the electrode layer ETL at the first end portion EP1 and/or other subsequent processes (for example, a pixel process for forming a pixel by using the light emitting element LD), may be formed with a sufficient thickness that may remain on the side surfaces of the second semiconductor layer SCL2 and the emission layer EML. For example, the insulating film INF may be formed with a thickness (for example, a thickness of about 10 nm or more) sufficient to stably surround the second semiconductor layer SCL2 and the light emitting layer EML, including an overetching margin that may occur in a subsequent process.

In the embodiment, the light emitting element LD may have a small size in a range of nanometers to micrometers. For example, the light emitting element LD may each have a diameter D (or a width of a lateral cross-section) and/or a length L ranging from a nanometer to micrometer. For example, the light emitting element LD may have a diameter D and/or a length L ranging from approximately several tens of nanometers to several tens of micrometers. However, the size of the light emitting element LD may be changed.

The structure, shape, size, and/or type of the light emitting element LD may be changed according to embodiments. For example, the structure, shape, size, and/or type of the light emitting element LD may be variously changed according to a design condition of a light emitting device using the light emitting element LD or a light emitting characteristic to be secured.

The light emitting device including the light emitting element LD may be used in various types of devices that require a light source. For example, the light emitting elements LD may be disposed in a pixel of a display device, and the light emitting elements LD may be used as a light source of the pixel. The light emitting element LD may be used in other types of devices that require a light source, such as a lighting device.

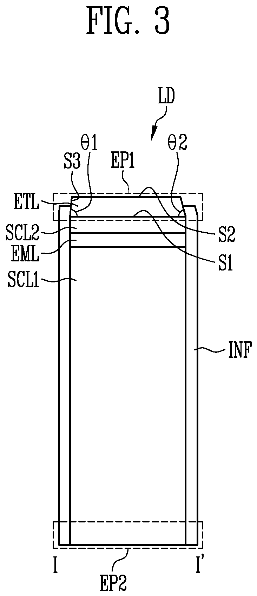

FIG. 3 to FIG. 7 respectively illustrate a cross-sectional view of a light emitting element LD according to an embodiment of the present invention. For example, FIG. 3 to FIG. 7 show different modified embodiments with respect to the embodiment of FIG. 2 in relation to the cross-section of the light emitting element LD corresponding to line I-I' of FIG. 1. In describing the embodiments of FIG. 3 to FIG. 7, the same reference numerals are denoted to configurations similar to or identical to those of the above-described embodiments, and duplicate descriptions thereof will be omitted.

Referring to FIG. 3, the electrode layer ETL may be left-right asymmetrical, and respective portions of the side surface S3 may have different angles and/or slopes. For example, on a longitudinal cross-section of the light emitting element LD, the side surface S3 of the electrode layer ETL may have a slope of a first angle θ1 on the left side and a slope of a second angle θ2 different from the first angle θ1 on the right side. In the embodiment, each of the first angle θ1 and the second angle θ2 may be in a range of about 75° to 90° (for example, a range of 80° or more, 90° or less or less than 90°). In addition, the electrode layer ETL may substantially have a slope corresponding to an angle of about 75° to 90° in the side surface S3. Accordingly, the insulating film INF may be formed with a sufficient thickness around the electrode layer ETL.

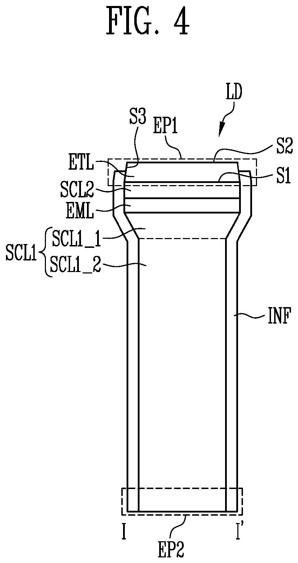

Referring to FIG. 4, the first semiconductor layer SCL1 may have a different width for each area and/or for each portion. For example, the first semiconductor layer SCL1 may have a larger etching ratio than that of the emission layer EML and/or the second semiconductor layer SCL2, and may have a smaller width and cross-sectional area in an area far from the emission layer EML than in an area close to the emission layer EML. For example, the first semiconductor layer SCL1 may include a first portion SCL1_1 adjacent to the emission layer EML and a second portion SCL1_2 excluding the first portion SCL1_1, and the first portion SCL1_1 may have a larger width and cross-sectional area than that of the second portion SCL1_2.

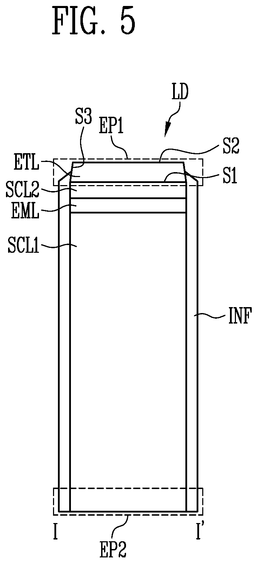

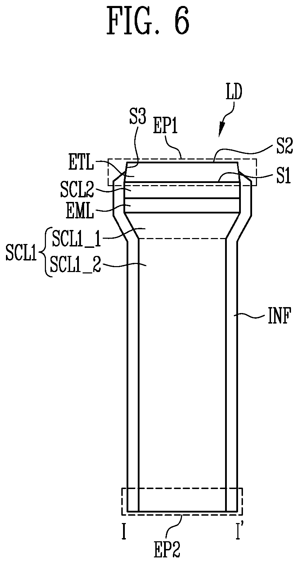

Referring to FIG. 5 and FIG. 6, the insulating film INF may have a different surface profile from a side shape of the electrode layer ETL (for example, a side profile of the electrode layer ETL) at the first end portion EP1. For example, at the first end portion EP1, the insulating film INF may have a thickness that is gradually changed, and may have a slope with an angle different from that of the slope of the side S3 of the electrode layer ETL. For example, the insulating film INF may have a thickness that increases as it approaches the emission layer EML at the first end portion EP1, and a thickness change rate of the insulating film INF at the first end portion EP1 may be larger than a width change rate of the electrode layer ETL according to the side slope of the electrode layer ETL.

In the embodiment, when the insulating film INF is formed by utilizing a chemical vapor deposition (CVD) process technology, compared to the case of forming the insulating film INF by using the ALD process technology, the step cover of the insulating film INF may be low. Accordingly, the insulating film INF may have a different surface profile from the side profile of the electrode layer ETL at the first end portion EP1 and the like.

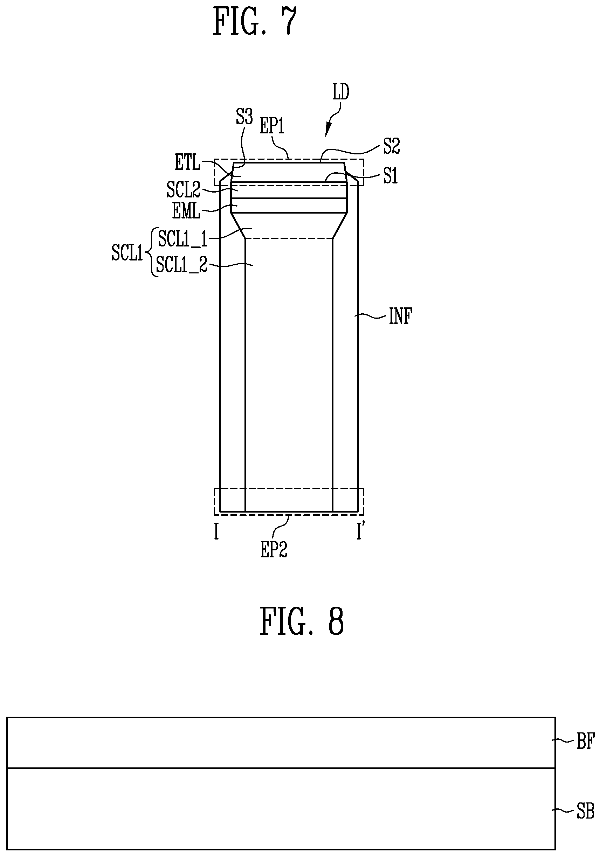

Referring to FIG. 7, in an embodiment in which the first portion SCL1_1 of the first semiconductor layer SCL1 has a width greater than that of the second portion SCL1_2 of the first semiconductor layer SCL1,, the insulating film INF does not follow the surface profile of the first semiconductor layer SCL1, but it may be formed with different thicknesses for each area and/or for each portion. For example, the insulating film INF may has a surface profile that is substantially perpendicular to the bottom surface (for example, the second end portion EP2) of the light emitting element LD regardless of a change in the width of the first semiconductor layer SCL1, and may have a larger thickness in a portion surrounding the second portion SCL1_2 of the first semiconductor layer SCL1 than a portion surrounding the first portion SCL1_1 of the first semiconductor layer SCL1.

In the embodiment, the insulating film INF is formed by using a process technology that provides a relatively low step coverage characteristic, or an additional process (for example, a process of additionally forming the insulating film INF by a partial thickness in a partial area thereof, or a process of etching the insulating film INF by a partial thickness in a partial area thereof) is performed after the insulating film INF is first formed, so that the insulating film INF may be formed to have a different thickness for each area and/or for each portion.

Even in the above-described embodiments, the side surface S3 of the electrode layer ETL may have a slope of about 75° to 90°. Accordingly, the insulating film INF may be formed with a sufficient thickness around the electrode layer ETL including the circumferential area of the bonding surface of the electrode layer ETL and the second semiconductor layer SCL2. Accordingly, even when the insulating film INF is partially etched in a subsequent process, the insulating film INF may remain on the surface of the light emitting element LD while stably surrounding the second semiconductor layer SCL2 and the emission layer EML.

FIG. 8 to FIG. 17 illustrate cross-sectional views of a manufacturing method of a light emitting element LD according to an embodiment of the present invention. For example, FIG. 8 to FIG. 17 sequentially illustrate a manufacturing method of the light emitting element LD according to the embodiment of FIG. 1 and FIG. 2. The light emitting element LD according to the embodiments of FIG. 3 to FIG. 7 may be manufactured through a manufacturing method that is substantially that same as or similar to that of the light emitting element LD according to the embodiment of FIG. 1 and FIG. 2. FIG. 8 to FIG. 17 illustrate an embodiment of manufacturing a plurality of light emitting elements LD on one substrate SB.

Referring to FIG. 1 to FIG. 8, first, the substrate SB (also referred to as a "growth substrate" or "manufacture substrate") may be prepared. In the embodiment, a buffer layer BF may be formed on the substrate SB.

The substrate SB may be a substrate or wafer suitable for epitaxial growth (or epitaxy) of a semiconductor. For example, the substrate SB may be a substrate including a material such as silicon (Si), sapphire, SiC, GaN, GaAs, or ZnO. In addition to this, the substrate SB may be a substrate of various types and/or materials. For example, when the epitaxial growth for manufacturing the light emitting element LD may be smoothly performed, the type or material of the substrate SB is not particularly limited. After the substrate SB is used as a substrate for the epitaxial growth for the manufacturing of the light emitting elements LD, it may be finally separated from the light emitting elements LD.

In the embodiment, the buffer layer BF may be formed on the substrate SB. The buffer layer BF may be formed through the epitaxial growth on the substrate SB, and may be finally separated from the light emitting elements LD. The buffer layer BF may be positioned between the light emitting elements LD and the substrate SB in the process of manufacturing the light emitting elements LD to physically separate the light emitting elements LD and the substrate SB. In the embodiment, the buffer layer BF may include an impurity undoped intrinsic semiconductor layer, and may include the same semiconductor material as the first semiconductor layer SCL1. In the embodiment, the buffer layer BF may include multi-layered semiconductor layers. One of the multi-layered semiconductor layers may be an intrinsic semiconductor layer. The other of the multi-layered semiconductor layers may be a semiconductor layer doped to include a dopant of a first or second conductivity type, and may reduce a strain between the substrate SB and the first semiconductor layer SCL1.

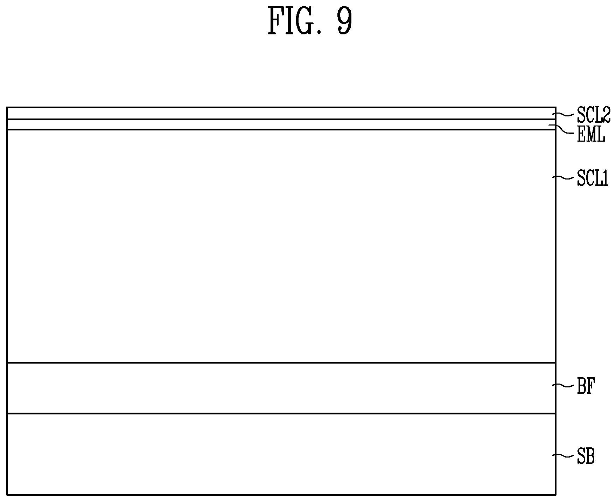

Referring to FIG. 9, the first semiconductor layer SCL1, the emission layer EML, and the second semiconductor layer SCL2 may be sequentially formed on the substrate SB. For example, the first semiconductor layer SCL1, the emission layer EML, and the second semiconductor layer SCL2 may be sequentially formed on the substrate SB on which the buffer layer BF is formed through the epitaxial growth.

The first semiconductor layer SCL1 may be made of the material of the first semiconductor layer SCL1 exemplified in the embodiment of FIG. 1 and FIG. 2, or other semiconductor materials. The first semiconductor layer SCL1 may be doped to include an N-type of dopant such as Si, Ge, Sn, or the like.

The first semiconductor layer SCL1 may be formed through epitaxial growth using a process technology such as metal-organic vapor phase epitaxy (MOVPE), metal-organic chemical vapor deposition (MOCVD), molecular beam epitaxy (MBE), liquid phase epitaxy (LPE), or vapor phase epitaxy (VPE), but the method of forming the first semiconductor layer SCL1 is not limited thereto.

The emission layer EML may be made of the material of the emission layer EML exemplified in the embodiment of FIG. 1 and FIG. 2 or other semiconductor materials. In the embodiment, the emission layer EML may be formed through epitaxial growth utilizing a process technology such as MOVPE, MOCVD, MBE, LPE, or VPE, but the method of forming the emission layer EML is not limited thereto.

The second semiconductor layer SCL2 may be made of the material of the second semiconductor layer SCL2 exemplified in the embodiment of FIG. 1 and FIG. 2, or other semiconductor materials. The second semiconductor layer SCL2 may be doped to include a P-type of dopant such as Mg. In the embodiment, the second semiconductor layer SCL2 may be formed through epitaxial growth utilizing a process technology such as MOVPE, MOCVD, MBE, LPE, or VPE, but the method of forming the second semiconductor layer SCL2 is not limited thereto.

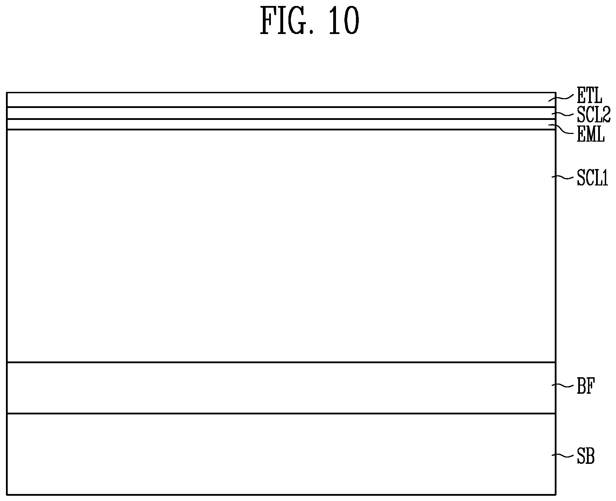

Referring to FIG. 10, the electrode layer ETL may be formed on the second semiconductor layer SCL2. For example, the electrode layer ETL may be entirely formed on one surface (for example, an upper surface) of the substrate SB in which the first semiconductor layer SCL1, the emission layer EML, and the second semiconductor layer SCL2 are sequentially formed. In the embodiment, the electrode layer ETL may be made of the material of the electrode layer ETL exemplified in the embodiment of FIG. 1 and 2 or other conductive materials.

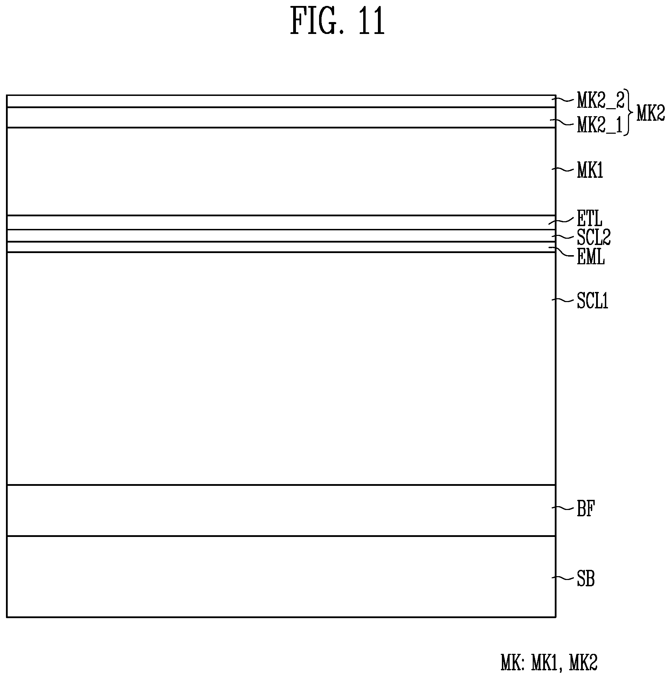

Referring to FIG. 11 to FIG. 14, by etching the first semiconductor layer SCL1, the emission layer EML, the second semiconductor layer SCL2, and the electrode layer ETL in a direction substantially perpendicular to the substrate SB, a multi-layered stacked body LES (also referred to as a "light emitting stacked body" or "light emitting core") including the first semiconductor layer SCL1, the emission layer EML, the second semiconductor layer SCL2, and the electrode layer ETL may be patterned in a rod shape. Accordingly, the light emitting element LD having the rod shape may be manufactured.

In the embodiment, the light emitting element LD may be patterned by a patterning process utilizing a nano imprint lithography process technology or a photo lithography process technology. For example, the light emitting element LD may be patterned by using the nano imprint lithography process technology.

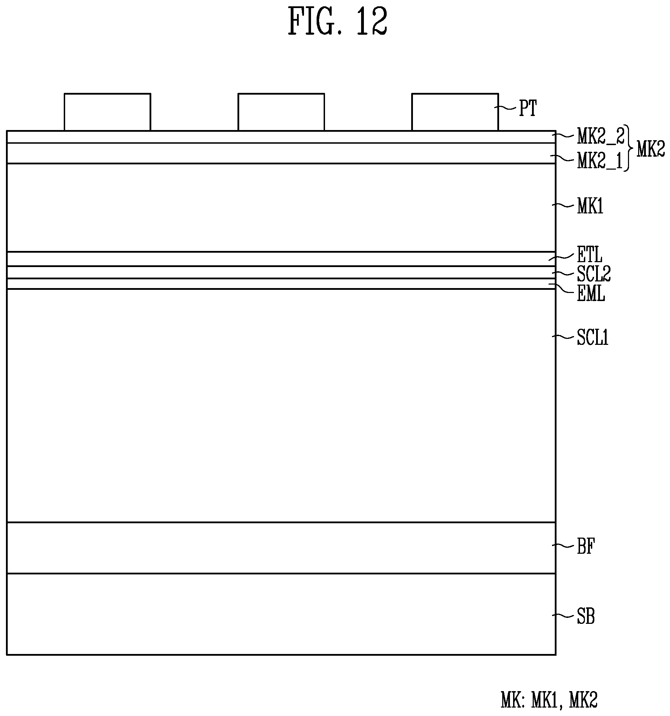

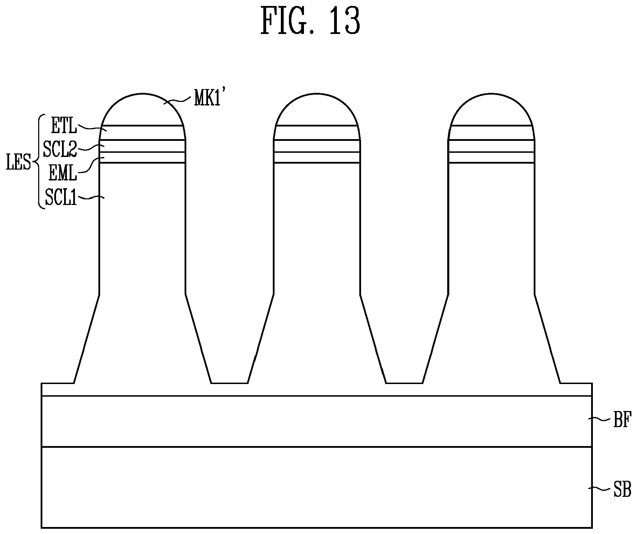

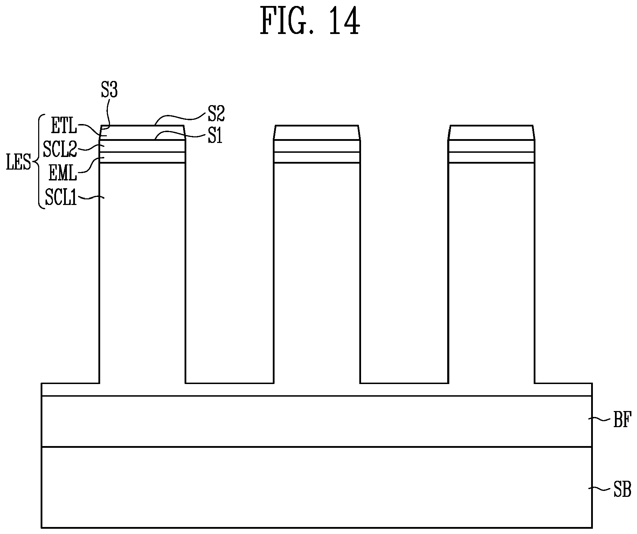

For example, as shown in FIG. 11, after forming a mask layer MK on the electrode layer ETL, as shown in FIG. 12, etching patterns PT (for example, nano patterns) may be formed on the mask layer MK. Then, the stacked body LES including the first semiconductor layer SCL1, the emission layer EML, the second semiconductor layer SCL2, and the electrode layer ETL may be etched in a desired shape such as a rod shape by an etching process using the mask layer MK and the etching patterns PT. For example, the first semiconductor layer SCL1, the emission layer EML, the second semiconductor layer SCL2, and the electrode layer ETL are etched in a vertical direction thereof by performing a dry etching process using the mask layer MK and the etching patterns PT, so that as shown in FIG. 13, the stacked body LES including the first semiconductor layer SCL1, the emission layer EML, the second semiconductor layer SCL2, and the electrode layer ETL may be substantially etched in a rod shape. Thereafter, by performing an additional etching process (for example, a wet etching process, etc.), each of the primarily etched stacks LES may be patterned in a rod shape, as shown in FIG. 14.

In the embodiment, the mask layer MK may include at least two mask layers made of different materials for selective dry etching for each layer and/or each film to be performed in a subsequent process. For example, a first mask layer MK1 (for example, a first hard mask layer) including an insulating material may be first formed on the electrode layer ETL, and then a second mask layer MK2 (for example, a second hard mask layer) including a conductive material may be formed on the first mask layer MK1.

The first mask layer MK1 may include a silicon oxide (SiOₓ) (for example, SiO₂), a silicon nitride (SiNₓ), a silicon oxynitride (SiOₓN_{y}), or other insulating materials.

The second mask layer MK2 may include at least one metal of aluminium (Al), titanium (Ti), and chromium (Cr), or other metals. In the embodiment, the second mask layer MK2 may include multi-layered metal layers MK2_1 and MK2_2 including different metals. For example, the second mask layer MK2 may include a first metal layer MK2_1 including titanium (Ti) and a second metal layer MK2_2 including aluminium (Al). The material and stacked structure of the second mask layer MK2 are not particularly limited. For example, when a material may serve as a mask for successive etching of the first semiconductor layer SCL1, the emission layer EML, the second semiconductor layer SCL2, and the electrode layer ETL, it may be used as a material of the second mask layer MK2. In addition, the second mask layer MK2 may be formed of a single layer or multilayer. As the second mask layer MK2 is formed, the first mask layer MK1 may be protected when the etch patterns PT are removed in a subsequent process.

The etching patterns PT may be disposed to be spaced apart from each other on the mask layer MK. The etching patterns PT may be formed in a shape, size, and/or spacing corresponding to the light emitting elements LD in order to pattern respective light emitting elements LD on the substrate SB. For example, the etching patterns PT may have a shape and size corresponding to the shape and diameter D of the light emitting elements LD to be manufactured, and may be spaced apart from each other by a distance sufficient to easily separate the light emitting elements LD.

The etching patterns PT may include polymer, or other materials. In the embodiment, the etching patterns PT may include a nano-imprint resin, and may be formed by utilizing a nano-imprint lithography process technology.

In the embodiment, the first semiconductor layer SCL1, the emission layer EML, the second semiconductor layer SCL2, and the electrode layer ETL may be primarily etched by a stepwise dry etching process using the etching patterns PT. For example, after first etching the second mask layer MK2 by using the etching patterns PT, the first mask layer MK1 may be etched. In addition, after the first mask layer MK1 is etched, the electrode layer ETL, the second semiconductor layer SCL2, the emission layer EML, and the first semiconductor layer SCL1 may be sequentially etched. In the embodiment, the electrode layer ETL, the second semiconductor layer SCL2, the emission layer EML, and the first semiconductor layer SCL1 may be etched in a substantially vertical direction thereof by a dry etching process to have a substantial rod shape as shown in FIG. 13. A first mask pattern MK1' formed by etching the first mask layer MK1 in a pattern corresponding to the etching patterns PT may remain on the electrode layer ETL even after the dry etching process of the electrode layer ETL, the second semiconductor layer SCL2, the emission layer EML, and the first semiconductor layer SCL1 is completed.

Thereafter, an additional etching process such as a dry etching process may be performed to etch the stacked body LES including the first semiconductor layer SCL1, the emission layer EML, the second semiconductor layer SCL2, and the electrode layer ETL in a rod shape.

In the embodiment, the mask layer MK used in the patterning process of the first semiconductor layer SCL1, the emission layer EML, the second semiconductor layer SCL2, and the electrode layer ETL may be formed in a sufficient thickness to etch the electrode layer ETL so that the electrode layer ETL has a slope corresponding to an angle of about 75° to 90° on the side surface S3. The thickness of the mask layer MK (for example, the thickness of the first mask layer MK1 and/or the thickness of the second mask layer MK2) may be experimentally determined according to process conditions.

For example, the mask layer MK may be formed to have a thickness suitable for etching the electrode layer ETL or the like within a short time by increasing etching power so that the side surface S3 of the electrode layer ETL may have a steep slope of 75° or more (for example, a slope in a range of 80° to 90°). For example, the mask layer MK may be formed to have a thickness of 2 µm or more.

In the embodiment, the first mask layer MK1 may be formed to have a thickness of 2 µm or more on the electrode layer ETL, and the second mask layer MK2 may be formed to have a thickness of 160 nm or more on the first mask layer MK1 by using the material different from that of the first mask layer MK1. In this case, the electrode layer ETL may be easily etched so that the electrode layer ETL has a side slope corresponding to an angle of about 75° to 90°. For example, the electrode layer ETL may be etched so as to have a slope corresponding to an angle of about 75° to 90° with respect to the substrate SB (or the first surface S1 of the electrode layer ETL).

The mask layer MK, the etching patterns PT, and/or the first mask patterns MK1' may be removed after respective etching processes using them are completed.

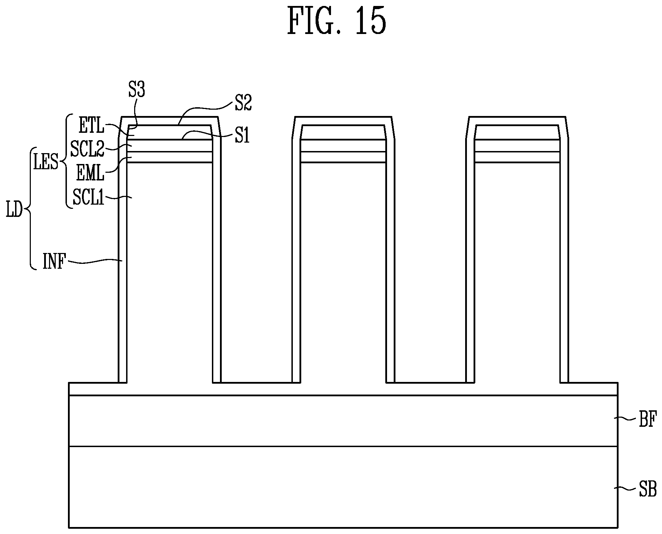

Referring to FIG. 15, the insulating film INF may be entirely formed on one surface (for example, the upper surface) of the substrate SB including the rod-shaped stacked bodies LES. In the embodiment, the insulating film INF may be made of the material of the insulating film INF exemplified in the embodiment of FIG. 1 and FIG. 2 or other insulating materials. In the embodiment, the insulating film INF may be formed by utilizing an ALD process technique, a CVD process technique, or the like, but the method of forming the insulating film INF is not limited thereto.

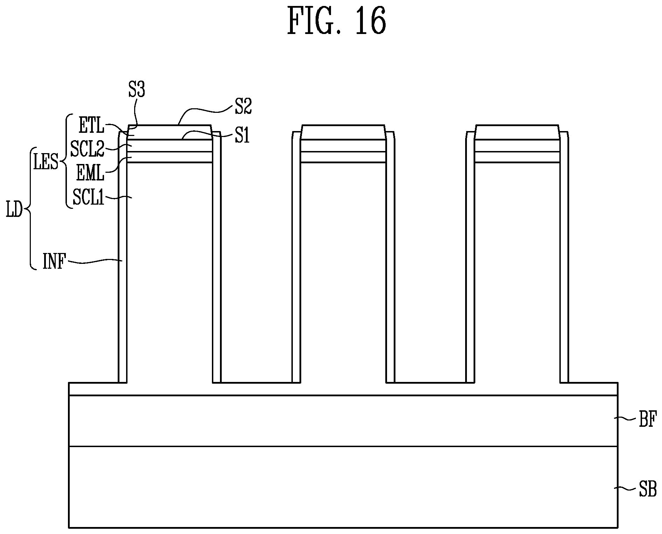

Referring to FIG. 16, the insulating film INF may be etched so that the second surface S2 of the electrode layer ETL is exposed. Accordingly, the insulating film INF may be formed on the side surface (for example, the side surfaces of the first semiconductor layer SCL1, the emission layer EML, the second semiconductor layer SCL2, and the electrode layer ETL configuring each rod-type stacked body LES) of each of the rod-shaped stacked bodies LES, and the electrode layer ETL may be exposed on the upper surface of each of the stacked bodies LES. Accordingly, each light emitting element LD including each stacked body LES and the insulating film INF provided on the side surface of the stacked body LES may be manufactured.

In the process of etching the insulating film INF, the insulating film INF may be partially etched even on the side surface S3 of the electrode layer ETL. For example, the insulating film INF may be partially etched and removed from the upper portion of the side surface S3 of the electrode layer ETL.

In the embodiment, in the case that the electrode layer ETL is formed such that the side surface S3 of the electrode layer ETL has a slope corresponding to an angle of a range of about 75° to 90°, it is possible to prevent or minimize the etching of the insulating film INF on the side surface S3 of the electrode layer ETL during the process of etching the insulating film INF to expose the second surface S2 of the electrode layer ETL. Accordingly, in the area corresponding to the bonding surface of the electrode layer ETL and the second semiconductor layer SCL2 (for example, the area surrounding the first surface S1 of the electrode layer ETL or the periphery thereof), the insulating film INF may remain with a sufficient thickness. For example, in the area corresponding to the bonding surface of the electrode layer ETL and the second semiconductor layer SCL2, the insulating film INF may remain with a thickness of about 10 nm or more. Accordingly, the insulating film INF may stably surround the second semiconductor layer SCL2 or the like.

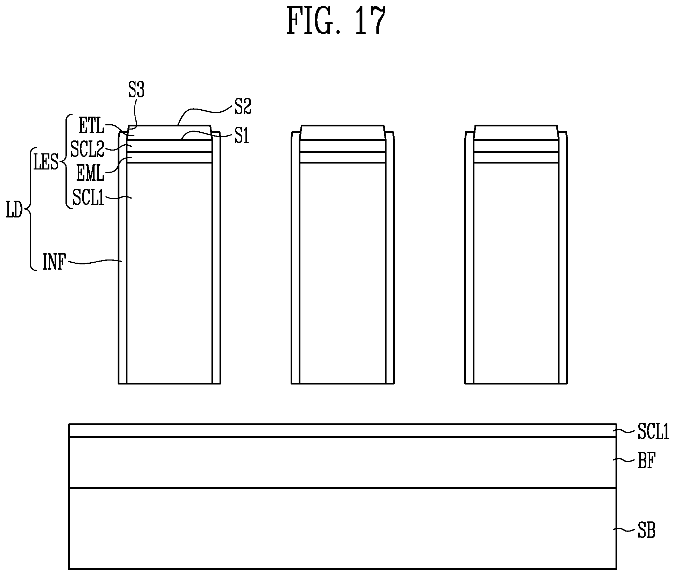

Referring to FIG. 17, the light emitting elements LD may be separated from the substrate SB. In the embodiment, the light emitting elements LD may be separated from the substrate SB by an electrical and/or chemical etching method, or other methods.

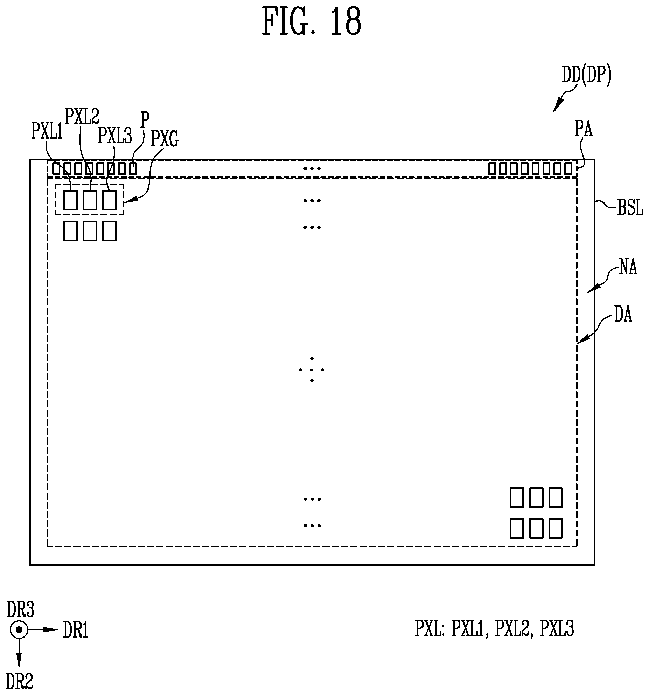

FIG. 18 illustrates a top plan view of a display device DD according to an embodiment of the present invention. FIG. 18 schematically illustrate a structure of the display device DD based on a display panel DP including a display area DA. The display device DD may further include a driving circuit (for example, a scan driver, a data driver, a timing controller, and the like) for driving pixels PXL.

Referring to FIG. 18, the display device DD may include a base layer BSL, and the pixels PXL disposed on the base layer BSL. The base layer BSL and the display device DD including the same may be provided in various shapes. For example, the base layer BSL and the display device DD may be provided in a plate shape having a substantially rectangular shape when viewed in a plan view, and may include angled or rounded corners. The shapes of the base layer BSL and the display device DD may be changed. For example, the base layer BSL and the display device DD may have polygonal shapes such as a hexagonal or octagonal shape when viewed in a plan view, or may have a shape including a curved line-type of circumference such as a circular or elliptical shape.

FIG. 18 illustrates the display device DD having a rectangular plate shape. In addition, a horizontal direction (for example, a row direction or a horizontal direction) of the display device DD is defined as a first direction DR1, a vertical direction (for example, a column direction or a vertical direction) of the display device DD is referred to as a second direction DR2, and a thickness direction (or a height direction) of the display device DD is referred to as a third direction DR3.

The base layer BSL may be a base member for configuring the display device DD. For example, the base layer BSL may configure a base surface of the display device DD.

The base layer BSL and the display device DD including the same may include a display area DA for displaying an image, and a non-display area NA positioned around the display area DA.

The display area DA is an area in which the pixels PXL are disposed, and may be an area in which an image is displayed by the pixels PXL. In the embodiment, the display area DA may be disposed in the base layer BSL and a central area of the display device DD (for example, a central area of the display panel DP).

The display area DA may have various shapes. For example, the display area DA may have various shapes including a rectangular shape, a circular shape, or an elliptical shape. In the embodiment, the display area DA may have a shape corresponding to the shape of the base layer BSL, but is not limited thereto.

The non-display area NA may be an area excluding the display area DA. In the embodiment, the non-display area NA may be disposed in edge areas of the base layer BSL and the display device DD to surround the display area DA. A portion of the non-display area NA may be a pad area PA in which pads P are disposed.

The pixels PXL may be disposed in the display area DA. For example, the display area DA may include a plurality of pixel areas in which respective pixels PXL are provided and/or disposed.

In the embodiment, at least two kinds of pixels PXL for emitting light of different colors may be disposed in the display area DA. For example, first color pixels PXL1, second color pixels PXL2, and third color pixels PXL3 may be arranged in the display area DA. At least one first color pixel PXL1, at least one second color pixel PXL2, and at least one third color pixel PXL3 disposed to be adjacent to each other may configure one pixel group PXG. By individually controlling the luminance of the first, second, and third color pixels PXL1, PXL2, and PXL3 in each pixel group PXG, the color of the light emitted from the pixel group PXG may be variously changed.

In the embodiment, the first color pixel PXL1, the second color pixel PXL2, and the third color pixel PXL3 sequentially arranged along the first direction DR1 may configure one pixel group PXG. In addition, the number, type, and/or mutual disposition structure of the pixels PXL configuring each pixel group PXG may be variously changed.

In the embodiment, the first color pixel PXL1 may be a red pixel for emitting red light, and the second color pixel PXL2 may be a green pixel for emitting green light. In addition, the third color pixel PXL3 may be a blue pixel for emitting blue light. In addition, the color of the light emitted from the pixels PXL configuring each pixel group PXG may be variously changed.

In the embodiment, each pixel PXL may include at least one light emitting element LD. For example, the pixel PXL may include the light emitting element LD according to at least one embodiment among the embodiments of FIG. 1 to FIG. 7. For example, the pixel PXL may include the light emitting element LD including the first semiconductor layer SCL1, the emission layer EML, the second semiconductor layer SCL2, the electrode layer ETL, and the insulating film INF, and the electrode layer ETL may include the side surface S3 having a slope of about 75° to 90°. In the embodiment, each light emitting element LD may have a size in a range of approximately nanometers to micrometers and may have a rod shape, but is not limited thereto. For example, the number, type, structure, and/or size of the light emitting elements LD provided to each pixel PXL may be changed according to embodiments.

In the embodiment, the first color pixel PXL1, the second color pixel PXL2, and the third color pixel PXL3 may be respectively provided with light emitting elements LD of the first color, the second color, and the third color as a light source. Accordingly, the first color pixel PXL1, the second color pixel PXL2, and the third color pixel PXL3 may emit light of the first color, light of the second color, and light of the third color, respectively.

In another embodiment, the first color pixel PXL1, the second color pixel PXL2, and the third color pixel PXL3 may include light emitting elements LD that emit light of the same color as each other, and a light converting layer including wavelength converting particles (for example, particles that convert the color and/or wavelength of light, such as quantum dots QD) may be disposed in a light emitting area of the first color pixel PXL1, the second color pixel PXL2, and/or the third color pixel PXL3. Accordingly, the first color pixel PXL1, the second color pixel PXL2, and the third color pixel PXL3 may emit light of the first color, light of the second color, and light of the third color, respectively.

For example, the first color pixel PXL1, the second color pixel PXL2, and the third color pixel PXL3 include blue light emitting elements, but a light converting layer including wavelength converting particles (for example, red quantum dots) of the first color may be disposed in the light emitting area of the first color pixel PXL1, and a light converting layer including wavelength converting particles (for example, green quantum dots) of the second color may be disposed in the light emitting area of the second color pixel PXL2. Accordingly, the first color pixel PXL1 may emit light of the first color (for example, red light), and the second color pixel PXL2 may emit light of the second color (for example, green light).

The pixels PXL may have a structure according to at least one of embodiments to be described below. For example, the pixels PXL may have a structure to which one of embodiments to be described later is applied, or a structure to which at least two embodiments are applied in combination.

In the embodiment, the pixel PXL may be configured as an active pixel, but is not limited thereto. For example, in another embodiment, the pixel PXL may be configured as a passive pixel.

In the non-display area NA, wires connected to the pixels PXL of the display area DA, and/or internal circuit parts may be disposed. In addition, a portion of the non-display area NA may be set as the pad area PA, and the pads P may be disposed to the pad area PA. The pads P may include signal pads and/or power pads to which various driving signals and/or powers necessary for driving the pixels PXL are applied.

In the embodiment, the non-display area NA may have a narrow width. For example, the non-display area NA may have a width of about 100 µm or less. Accordingly, the display device DD may be implemented as a bezel-less display device.

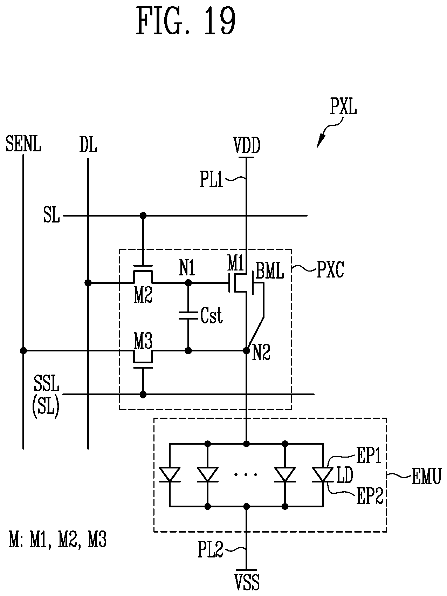

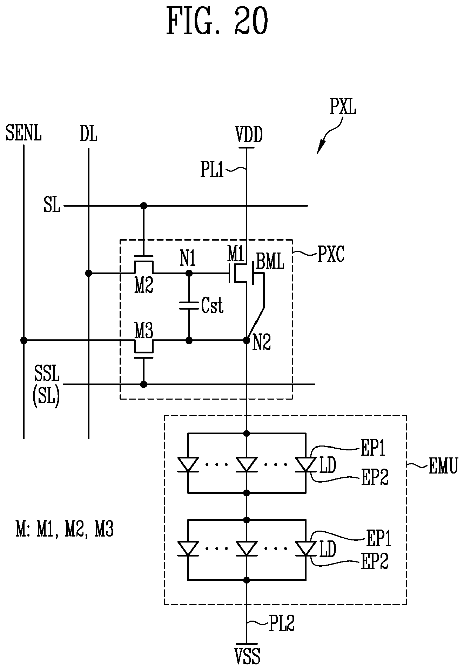

FIG. 19 and FIG. 20 respectively illustrate a circuit diagram of the pixel PXL according to the embodiment of the present invention. For example, FIG. 19 and FIG. 20 illustrate the pixels PXL including light emitting parts EMU having different structures.

In some embodiments, each pixel PXL illustrated in FIG. 19 and FIG. 20 may be one of the pixels PXL disposed in the display area DA of FIG. 18. The pixels PXL may have substantially the same or similar structure to each other.

Referring to FIG. 19 and FIG. 20, the pixel PXL may be connected to a scan line SL (also referred to as a "first scan line"), a data line DL, a first power line PL1, and a second power line PL2. In addition, the pixel PXL may be further connected to at least one other power line and/or signal line. For example, the pixel PXL may be further connected to a sensing line SENL (also referred to an "initialization power line") and/or a control line SSL (also referred to as a "second scan line").

The pixel PXL may include the light emitting part EMU for generating light of luminance corresponding to each data signal. In addition, the pixel PXL may further include a pixel circuit PXC for driving the light emitting part EMU.

The pixel circuit PXC may be connected to the scan line SL and the data line DL, and may be connected between the first power line PL1 and the light emitting part EMU. For example, the pixel circuit PXC may be electrically connected to the scan line SL to which a first scan signal is supplied, the data line DL to which a data signal is supplied, the first power line PL1 to which a voltage of a first power source VDD is applied, and the light emitting part EMU.

The pixel circuit PXC may be selectively further connected to the control line SSL to which a second scan signal is supplied, and the sensing line SENL connected to a reference power source (or initialization power source) or a sensing circuit in response to a display period or sensing period. In the embodiment, the second scan signal may be the same as or different from the first scan signal. When the second scan signal is the same signal as the first scan signal, the control line SSL may be integrated with the scan line SL.

The pixel circuit PXC may include at least one transistor M and a capacitor Cst. For example, the pixel circuit PXC may include a first transistor M1, a second transistor M2, a third transistor M3, and the capacitor Cst.

The first transistor M1 may be connected between the first power line PL1 and a second node N2. The second node N2 may be a node at which the pixel circuit PXC and the light emitting part EMU are connected to each other. For example, the second node N2 may be a node in which one electrode (for example, a source electrode) of the first transistor M1 and the light emitting part EMU are electrically connected to each other. A gate electrode of the first transistor M1 may be connected to a first node N1. The first transistor M1 may control a driving current supplied to the light emitting part EMU in response to a voltage of the first node N1. For example, the first transistor M1 may be a driving transistor of the pixel PXL.

In the embodiment, the first transistor M1 may further include a bottom metal layer BML (also referred to as "back gate electrode" or "second gate electrode"). In the embodiment, the bottom metal layer BML may be connected to one electrode (for example, a source electrode) of the first transistor M1.

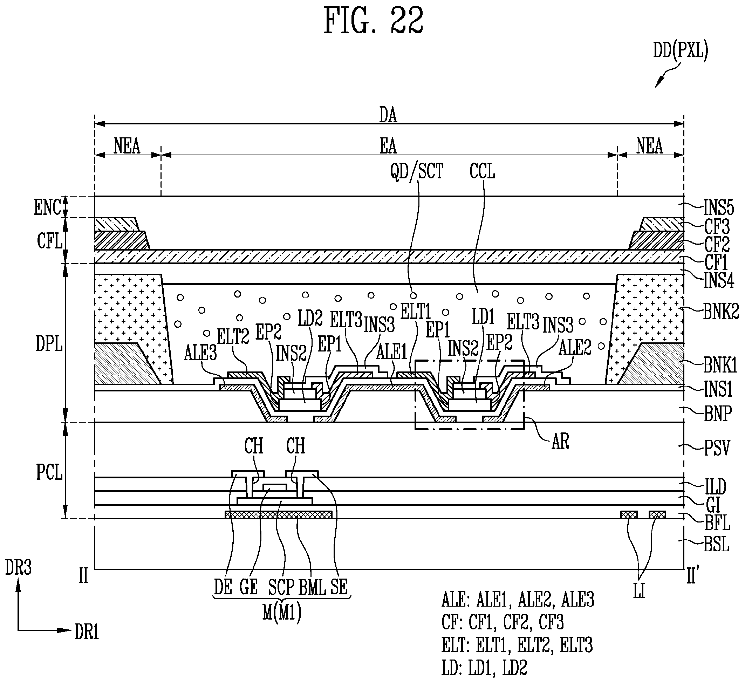

In the embodiment in which the first transistor M1 includes the bottom metal layer BML, by applying a back-biasing voltage to the bottom metal layer BML of the first transistor M1, a back-biasing technique (or a sync technique) of moving a threshold voltage of the first transistor M1 in a negative or positive direction may be applied. In addition, when the bottom metal layer BML is disposed under a semiconductor pattern (for example, the semiconductor pattern SCP of FIG. 22) configuring a channel of the first transistor M1, it may block the light incident on the semiconductor pattern to stabilize operating characteristics of the first transistor M1.

The second transistor M2 may be connected between the data line DL and the first node N1. A gate electrode of the second transistor M2 may be connected to a scan line SL. When a first scan signal of a gate-on voltage (for example, a logic high voltage or a high level voltage) is supplied from the scan line SL, the second transistor M2 may be turned on to connect the data line DL and the first node N1.

For each frame period, a data signal of the corresponding frame may be supplied to the data line DL, and the data signal may be transmitted to the first node N1 through the second transistor M2 during a period in which the first scan signal of the gate-on voltage is supplied. For example, the second transistor M2 may be a switching transistor for transmitting each data signal to the inside of the pixel PXL.

A first electrode of the capacitor Cst may be connected to the first node N1, and the second electrode of the capacitor Cst may be connected to the second node N2. The capacitor Cst may be charged with a voltage corresponding to the data signal supplied to the first node N1 during each frame period.

The third transistor M3 may be connected between the second node N2 and the sensing line SENL. In addition, a gate electrode of the third transistor M3 may be connected to the control line SSL (or the scan line SL). The third transistor M3 may be turned on when the second scan signal (or first scan signal) of a gate-on voltage (for example, a logic high voltage or high level voltage) is supplied from the control line SSL to transmit the reference voltage (or initialization voltage) supplied to the sensing line SENL to the second node N2 or to transmit the voltage of the second node N2 to the sensing line SENL. In the embodiment, the voltage of the second node N2 may be transmitted to the sensing circuit through the sensing line (SENL), and may be provided to the driving circuit (for example, timing controller) to be used for compensating the characteristic deviation of the pixels PXL.

In FIG. 19 and FIG. 20, all of the transistors M included in the pixel circuit PXC are illustrated as N-type transistors, but embodiments are not limited thereto. For example, at least one of the first, second, and third transistors M1, M2, and M3 may be changed to a P-type transistor. The structure and driving method of the pixel PXL may be variously changed according embodiments.

The light emitting part EMU may include at least one light emitting element LD. In the embodiment, the light emitting part EMU may include a single light emitting element LD connected in a forward direction between the first power source VDD and the second power source VSS. In another embodiment, the light emitting part EMU may include a plurality of light emitting elements LD that are connected in a forward direction between the first power source VDD and the second power source VSS. At least one light emitting element LD connected in a forward direction between the first power source VDD and the second power source VSS may configure an effective light source of the pixel PXL.

In the embodiment, the light emitting part EMU may include the light emitting elements LD connected in parallel between the pixel circuit PXC and the second power line PL2 as in the embodiment of FIG. 19. The first end portions EP1 of the light emitting elements LD may be electrically connected to the pixel circuit PXC, and may be electrically connected to the first power line PL1 through the pixel circuit PXC. The second end portions EP2 of the light emitting elements LD may be electrically connected to the second power line PL2. A voltage of the second power source VSS may be applied to the second power line PL2.

The number, type, and/or structure of the light emitting elements LD configuring the effective light source of the pixel PXL may be changed according to embodiments. In addition, the arrangement and/or connection structure of the light emitting elements LD may also be changed according to embodiments.

In the embodiment, the light emitting part EMU may include the light emitting elements LD connected in parallel-series between the pixel circuit PXC and the second power line PL2 as in the embodiment of FIG. 20. For example, the light emitting elements LD may be arranged and/or connected to at least two serial stages between the pixel circuit PXC and the second power line PL2, and each serial stage may include at least one light emitting element LD connected in a forward direction between the first power source VDD and the second power source VSS.

The first power source VDD and the second power source VSS may have different potentials. For example, the first power source VDD may be a high potential pixel power source, and the second power source VSS may be a low potential pixel power source. A potential difference between the first power source VDD and the second power source VSS may be greater than or equal to a threshold voltage of the light emitting elements LD.

The light emitting elements LD may emit light with luminance corresponding to a driving current supplied through the pixel circuit PXC. During each frame period, the pixel circuit PXC may supply a driving current corresponding to the data signal to the light emitting part EMU. The driving current supplied to the light emitting part EMU may flow through the light emitting elements LD to cause the light emitting elements LD to emit light. Accordingly, the light emitting part EMU may emit light with a luminance corresponding to the driving current.

FIG. 19 and FIG. 20 illustrate only light emitting elements LD (that is, effective light sources) connected in a forward direction between the first power source VDD and the second power source VSS, but embodiments are not limited thereto. For example, the light emitting part EMU may further include at least one ineffective light source in addition to the light emitting elements LD configuring each effective light source. For example, the light emitting part EMU may further include at least one ineffective light emitting element arranged in a reverse direction between the first power source VDD and the second power source VSS, or having at least one end portion of which is floating.

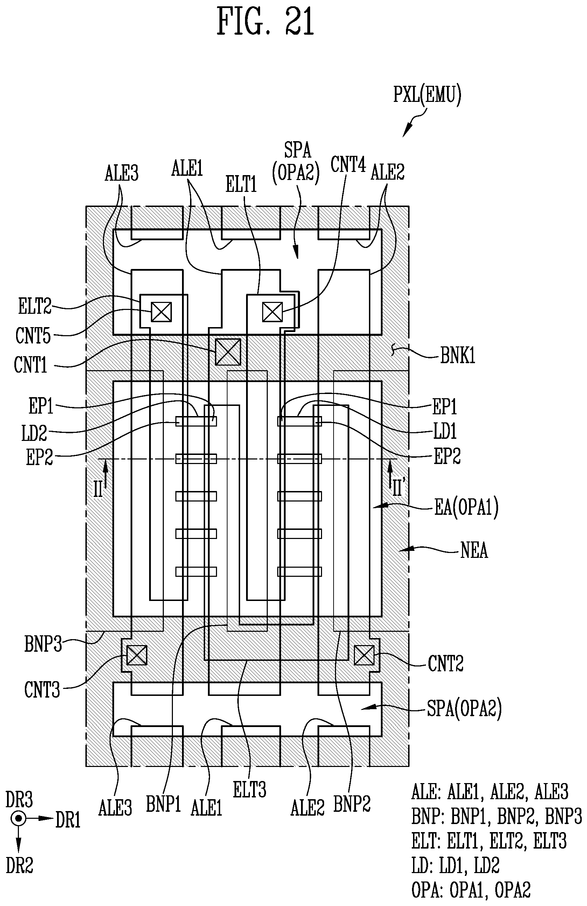

FIG. 21 illustrates a top plan view of a pixel PXL according to an embodiment of the present invention. For example, FIG. 21 illustrates a structure of the pixel PXL based on the light emitting part EMU, and illustrates an embodiment of the light emitting part EMU including the light emitting elements LD that are connected in series-parallel to each other as in the embodiment of FIG. 20.

Referring to FIG. 1 to FIG. 21, the pixel PXL may include a light emitting area EA in which at least one light emitting element LD is disposed. In the embodiment, the light emitting area EA may include at least two light emitting elements LD, and electrodes electrically connected to the light emitting elements LD. In the embodiment, the electrodes may include alignment electrodes ALE and pixel electrodes ELT (also referred to as "contact electrodes"). In addition, the pixel PXL may further include bank patterns BNP disposed under the alignment electrodes ALE.

The alignment electrodes ALE may have various shapes, and may be spaced apart from each other. In the embodiment, the alignment electrodes ALE may be spaced apart from each other along the first direction DR1, and each thereof may have an extended shape (for example, a bar shape) along the second direction DR2.

The shape, size, number, position, and/or mutual disposition structure of the alignment electrodes ALE may be variously changed according to embodiments. In addition, the alignment electrodes ALE may have a shape and/or size similar to or the same as each other, or may have different shapes and sizes.

The alignment electrodes ALE may include at least two electrodes spaced apart from each other. For example, the alignment electrodes ALE may include a first alignment electrode ALE1 and a second alignment electrode ALE2, and may optionally further include a third alignment electrode ALE3.

In the embodiment, the first alignment electrode ALE1 may be positioned at a center of the light emitting area EA, and the second alignment electrode ALE2 and the third alignment electrode ALE3 may be disposed at both sides of the first alignment electrode ALE1. For example, the second alignment electrode ALE2 may be disposed at the right side of the first alignment electrode ALE1, and the third alignment electrode ALE3 may be disposed at the left side of the first alignment electrode ALE1.

The alignment electrodes ALE (or, alignment lines before being separated into the alignment electrodes ALE of each of the pixels PXL) may receive alignment signals necessary for aligning the light emitting elements LD in an aligning step of the light emitting elements LD. Accordingly, an electric field is formed between the alignment electrodes ALE, so that the light emitting elements LD may be aligned and/or arranged between the alignment electrodes ALE. Here, when the light emitting elements LD are aligned and/or arranged between the alignment electrodes ALE, it means that at least a portion of each of the light emitting elements LD is disposed between the alignment electrodes ALE.

For example, the first alignment electrode ALE1, the second alignment electrode ALE2, and the third alignment electrode ALE3 (or a first alignment line in which the first alignment electrodes ALE1 of the pixels PXL are connected, a second alignment line in which the second alignment electrodes ALE2 of the pixels PXL are connected, and a third alignment line in which the third alignment electrodes ALE3 of the pixels PXL are connected) may receive a first alignment signal, a second alignment signal, and a third alignment signal in the aligning step of the light emitting elements LD, respectively. The first alignment signal and the second alignment signal may have different waveforms, potentials, and/or phases. Accordingly, an electric field is formed between the first alignment electrode ALE1 and the second alignment electrode ALE2, so that the light emitting elements LD (for example, first light emitting elements LD1) may be aligned between the first alignment electrode ALE1 and the second alignment electrode ALE2. The first alignment signal and the third alignment signal may have different waveforms, potentials, and/or phases. Accordingly, an electric field is formed between the first alignment electrode ALE1 and the third alignment electrode ALE3, so that the light emitting elements LD (for example, second light emitting elements LD2) may be aligned between the first alignment electrode ALE1 and the third alignment electrode ALE3. The third alignment signal may be the same as or different from the second alignment signal.

The alignment electrodes ALE may be disposed in the light emitting area EA of each pixel PXL. In the embodiment, the alignment electrodes ALE may extend to a separation area SPA past the non-light emitting area NEA around the light emitting area EA. The separation area SPA may be an area in which each alignment line (for example, the first alignment line, the second alignment line, or the third alignment line) is separated into the alignment electrodes ALE (for example, the first alignment electrodes ALE1, the second alignment electrodes ALE2, or the third alignment electrodes ALE3 of the pixels PXL) of the pixels PXL after alignment of the light emitting elements LD is completed, and may be disposed on at least one side of each light emitting area EA.

For example, each pixel PXL has at least one separation area SPA disposed around the light emitting area EA (for example, two separation areas SPA disposed above and below each light emitting area EA). In addition, end portions of at least one electrode configuring the light emitting part EMU (for example, end portions of the alignment electrodes ALE) may be disposed in each separation area SPA.

In the embodiment, each alignment electrode ALE may have a separated pattern for each pixel PXL. For example, the first, second, and third alignment electrodes ALE1, ALE2, and ALE3 of each of the pixels PXL may respectively have an individually separated pattern.

However, the present invention is not limited thereto. For example, in a structure in which the second pixel electrodes ELT2 of the pixels PXL are commonly connected to the second power line PL2, the alignment electrodes ALE (for example, the third alignment electrodes ALE3 of the pixels PXL) connected to the second pixel electrodes ELT2 are integrated with each other without being disconnected between the pixels PXL adjacent to each other along the first direction DR1 and/or the second direction DR2.

In the embodiment, the first alignment electrode ALE1 may be electrically connected to the pixel circuit PXC (for example, the pixel circuit PXC of the corresponding pixel PXL) positioned in the circuit layer (for example, the circuit layer PCL of FIG. 22) and/or the first power line PL1 through a first contact portion CNT1. In this case, the first alignment signal may be supplied to the first alignment electrode ALE1 (or the first alignment wire) through at least one wire (for example, the first power line PL1) positioned in the circuit layer.

The first contact portion CNT1 may include at least one contact hole and/or via hole. In the embodiment, the first contact portion CNT1 may be positioned in the non-light emitting area NEA positioned around each light emitting area EA, but the position of the first contact portion CNT1 may be changed. For example, the first contact portion CNT1 may be disposed to each light emitting area EA or separation area SPA.

In the embodiment, the second alignment electrode ALE2 may be electrically connected to the second power line PL2 positioned in the circuit layer through a second contact portion CNT2. In this case, the second alignment signal may be supplied to the second alignment electrode ALE2 (or the second alignment wire) through the second power line PL2.

Similarly, the third alignment electrode ALE3 may be electrically connected to the second power line PL2 positioned in the circuit layer through a third contact portion CNT3. In this case, the second alignment signal may also be supplied to the third alignment electrode ALE3 (or the third alignment wire) through the second power line PL2.

The second contact portion CNT2 and the third contact portion CNT3 may each include at least one contact hole and/or via hole. In the embodiment, the second contact portion CNT2 and the third contact portion CNT3 may be positioned in the non-light emitting area NEA positioned around each light emitting area EA, but the positions of the second contact portion CNT2 and the third contact portion CNT3 may be changed. For example, the second contact portion CNT2 and the third contact portion CNT3 may be disposed to each light emitting area EA or separation area SPA.

At least one first light emitting element LD1 may be disposed between the first alignment electrode ALE1 and the second alignment electrode ALE2. For example, a plurality of first light emitting elements LD1 may be arranged between the first alignment electrode ALE1 and the second alignment electrode ALE2.

Each of the first light emitting elements LD1 may or may not overlap the first alignment electrode ALE1 and/or the second alignment electrode ALE2. The first end portion EP1 of the first light emitting element LD1 may be disposed to be adjacent to the first alignment electrode ALE1, and the second end portion EP2 of the first light emitting element LD1 may be disposed to be adjacent to the second alignment electrode ALE2.

The first end portion EP1 of the first light emitting element LD1 may be electrically connected to the first pixel electrode ELT1. In the embodiment, the first end EP1 of the first light emitting element LD1 may be electrically connected to the first alignment electrode ALE1 through the first pixel electrode ELT1, and may be electrically connected to the pixel circuit PXC and/or the first power line PL1 through the first alignment electrode ALE1.

The second end portion EP2 of the first light emitting element LD1 may be electrically connected to the third pixel electrode ELT3 and/or the second pixel electrode ELT2. In the embodiment, the second end portion EP2 of the first light emitting element LD1 may be electrically connected to the third pixel electrode ELT3. In addition, the second end portion EP2 of the first light emitting element LD1 may be electrically connected to the second power line PL2 sequentially via the third pixel electrode ELT3, at least one second light emitting element LD2, the second pixel electrode ELT2, and the third alignment electrode ALE3.

At least one second light emitting element LD2 may be disposed between the first alignment electrode ALE1 and the third alignment electrode ALE3. For example, a plurality of second light emitting elements LD2 may be arranged between the first alignment electrode ALE1 and the third alignment electrode ALE3.

Each of the second light emitting elements LD2 may or may not overlap the first alignment electrode ALE1 and/or the third alignment electrode ALE3. The first end portion EP1 of the second light emitting element LD2 may be disposed to be adjacent to the first alignment electrode ALE1, and the second end portion EP2 of the second light emitting element LD2 may be disposed to be adjacent to the third alignment electrode ALE3.

The first end portion EP1 of the second light emitting element LD2 may be electrically connected to the third pixel electrode ELT3. The second end portion EP2 of the second light emitting element LD2 may be electrically connected to the second pixel electrode ELT2. In the embodiment, the second end portion EP2 of the second light emitting element LD2 may be electrically connected to the third alignment electrode ALE3 through the second pixel electrode ELT2, and may be electrically connected to the second power line PL2 through the third alignment electrode ALE3.

For example, each light emitting element LD (for example, each first light emitting element LD1 or second light emitting element LD2) may include the first end portion EP1 electrically connected to the first pixel electrode ELT1 and the second end portion EP2 electrically connected to the second pixel electrode ELT2. In the embodiment, each light emitting element LD may be an ultra-small inorganic light emitting element using a material having an inorganic crystalline structure (for example, having a small size in a range of nanometers to micrometers). For example, each light emitting element LD may be an ultra-small inorganic light emitting element manufactured by growing a nitride-based semiconductor or a phosphide-based semiconductor. However, the type, size, shape, structure, and/or number of light emitting elements LD configuring each light emitting part EMU may be changed.

The light emitting elements LD may be dispersed in a solution to be prepared in a form of a light emitting element mixture solution (or light emitting element ink), and may be supplied to each light emitting area EA by an inkjet method or a slit coating method. When the alignment signals are applied to the alignment electrodes ALE (or alignment lines) of the pixels PXL simultaneously with or after the supply of the light emitting elements LD, an electric field may be formed between the alignment electrodes ALE so that the light emitting elements LD may be aligned. After the alignment of the light emitting elements LD is completed, the solvent may be removed through a drying process.

The first pixel electrode ELT1 (also referred to as a "first electrode") may be disposed on the first end portions EP1 of the first light emitting elements LD1, and may be electrically connected to the first end portions EP1 of the first light emitting elements LD1. As an example, the first pixel electrode ELT1 may be directly disposed on the first end portions EP1 of the first light emitting elements LD1 to be in contact with the first end portions EP1 of the first light emitting elements LD1.

In the embodiment, the first pixel electrode ELT1 may overlap the first alignment electrode ALE1, and may be electrically connected to the first alignment electrode ALE1 through a fourth contact portion CNT4. In addition, the first pixel electrode ELT1 may be electrically connected to the pixel circuit PXC and/or the first power line PL1 through the first alignment electrode ALE1. In another embodiment, the first pixel electrode ELT1 may be electrically connected to the pixel circuit PXC and/or the first power line PL1 without through the first alignment electrode ALE1.

The third pixel electrode ELT3 may be disposed on the second end portions EP2 of the first light emitting elements LD1 and the first end portions EP1 of the second light emitting elements LD2, and may be electrically connected to the second end portions EP2 of the first light emitting elements LD1 and the first end portions EP1 of the second light emitting elements LD2. For example, the third pixel electrode ELT3 may be directly disposed on the second end portions EP2 of the light emitting elements LD1 and the first end portions EP1 of the second light emitting elements LD2 to be in contact with the second end portions EP2 of the first light emitting elements LD1 and the first end portions EP1 of the second light emitting elements LD2. The third pixel electrode ELT3 may be a middle electrode for electrically connecting the first light emitting elements LD1 and the second light emitting elements LD2. In the embodiment, the third pixel electrode ELT3 may overlap a portion of each of the first and second alignment electrodes ALE1 and ALE2, but is not limited thereto.

The second pixel electrode ELT2 (also referred to as a "second electrode") may be disposed on the second end portions EP2 of the second light emitting elements LD2, and may be electrically connected to the second end portions EP2 of the second light emitting elements LD2. As an example, the second pixel electrode ELT2 may be directly disposed on the second end portions EP2 of the second light emitting elements LD2 to be in contact with the second end portions EP2 of the second light emitting elements LD2.

In the embodiment, the second pixel electrode ELT2 may overlap the third alignment electrode ALE3, and may be electrically connected to the third alignment electrode ALE3 through a fifth contact portion CNT5. In addition, the second pixel electrode ELT2 may be electrically connected to the second power line PL2 through the third alignment electrode ALE3. In another embodiment, the second pixel electrode ELT2 may be electrically connected to the second power line PL2 without passing through the third alignment electrode ALE3.

The pixel electrodes ELT (for example, the first pixel electrode ELT1, the second pixel electrode ELT2, and the third pixel electrode ELT3) may be formed separately from each other in each light emitting area EA. In the embodiment, at least one pixel electrode ELT may extend from each light emitting area EA to the non-light emitting area NEA and/or the separation area SPA. For example, the first pixel electrode ELT1 and the second pixel electrode ELT2 may extend from the light emitting area EA to the non-light emitting area NEA and the separation area SPA, and may be electrically connected to the first alignment electrode ALE1 and the third alignment electrode ALE3 in the separation area SPA, respectively. The third pixel electrode ELT3 may be formed only in each light emitting area EA, or a portion thereof may be positioned in the non-light emitting area NEA. The position, size, shape, and mutual disposition structure of the pixel electrodes ELT, and/or the positions of the fourth and fifth contact portions CNT4 and CNT5 may be variously changed according to embodiments.

The bank patterns BNP (also referred to as "patterns" or "wall patterns") may be disposed under the alignment electrodes ALE to overlap some of the alignment electrodes ALE. For example, each of the bank patterns BNP may include a first bank pattern BNP1, a second bank pattern BNP2, and a third bank pattern BNP3 overlapping portions of the first alignment electrode ALE1, the second alignment electrode ALE2, and the third alignment electrode ALE3, respectively. In the embodiment, at least one bank pattern BNP may extend to the non-light emitting area NEA around the light emitting area EA, but is not limited thereto.

Some of the alignment electrodes ALE may protrude in an upper direction (for example, the third direction DR3) of the pixel PXL by the bank patterns BNP. Accordingly, it is possible to easily control the area in which the light emitting elements LD are aligned, and by reflecting light directed to the bank patterns BNP at a low angle among light emitted from the light emitting elements LD in an upper direction the pixel PXL, it is possible to increase the light efficiency of the pixel PXL.

In the embodiment, at least two adjacent pixels PXL may share at least one bank pattern BNP. For example, the second bank pattern BNP2 may be integrally formed with the third bank pattern BNP3 of the pixel PXL (for example, an adjacent pixel at the right side) adjacent in the first direction DR1. Similarly, the third bank pattern BNP2 may be integrally formed with the second bank pattern BNP2 of another adjacent pixel (for example, an adjacent pixel at the left side) in the first direction DR1. The position, structure, number, and/or shape of the bank patterns BNP may be variously changed according to embodiments.

The non-light emitting area NEA may be disposed around each light emitting area EA and/or each separation area SPA. The first bank BNK1 may be disposed in the non-light emitting area NEA.

The first bank BNK1 may include a first opening OPA1 corresponding to each light emitting area EA, and may surround the light emitting area EA. In addition, the first bank BNK1 may include second openings OPA2 corresponding to the separation areas SPA, and may surround the separation areas SPA. For example, the first bank BNK1 may include a plurality of openings OPA corresponding to each light emitting area EA and each separation area SPA.

The first bank BNK1 may include at least one light blocking and/or reflective material. For example, the first bank BNK1 may include at least one of a black matrix material and/or a color filter material of a specific color. Accordingly, light leakage between adjacent pixels PXL may be prevented.

The first bank BNK1 may define each light emitting area EA in which the light emitting elements LD should be supplied at the step of supplying the light emitting elements LD to each pixel PXL. For example, the light emitting areas EA of the pixels PXL are separated and partitioned by the first bank BNK1, so that a desired type and/or amount of light emitting element mixture solution may be supplied into each light emitting area EA.

In the embodiment, the first bank BNK1 may include a hydrophobic surface. For example, by forming the first bank BNK1 itself in a hydrophobic pattern by using a hydrophobic material, or by forming a hydrophobic film made of a hydrophobic material on the first bank BNK1, the first bank BNK1 may be formed to have the hydrophobic surface. For example, the first bank BNK1 may be formed by using a hydrophobic organic insulating material having a large contact angle, such as polyacrylate, and accordingly, the first bank BNK1 may be formed in a hydrophobic pattern. Accordingly, the light emitting element mixture solution may stably flow into the light emitting area EA.

FIG. 22 illustrates a cross-sectional view of a display device DD according to an embodiment of the present invention. For example, FIG. 22 illustrates an embodiment of a cross-section of the display device DD based on a cross-section of the pixel PXL corresponding to line II-II' of FIG. 21.

Referring to FIG. 1 to FIG. 22, the display device DD may include a base layer BSL, a circuit layer PCL, and a display layer DPL. The circuit layer PCL and the display layer DPL may be provided to overlap each other on the base layer BSL. For example, the circuit layer PCL and the display layer DPL may be sequentially disposed on one surface of the base layer BSL.

The display device DD may further include a color filter layer CFL and/or an encapsulation layer ENC (or a passivation layer) disposed on the display layer DPL. In the embodiment, the color filter layer CFL and/or the encapsulation layer ENC may be directly formed on one surface of the base layer BSL on which the circuit layer PCL and the display layer DPL are formed, but are not limited thereto.

The base layer BSL may be a substrate or film of a rigid or flexible material. In the embodiment, the base layer BSL may include at least one insulating material that is transparent or opaque, and may have a single-layered or multi-layered structure.

The circuit layer PCL may be provided on one surface of the base layer BSL. The circuit layer PCL may include circuit elements configuring a pixel circuit PXC of each pixel PXL. For example, a plurality of circuit elements (for example, transistors M and a capacitor Cst configuring each pixel circuit PXC) may be formed in each pixel area of the circuit layer PCL.

FIG. 22 illustrates, as an example of circuit elements that may be disposed on the circuit layer PCL, one transistor M provided in each pixel circuit PXC (for example, the first transistor M1 including the bottom metal layer BML).

In addition, the circuit layer PCL may include various signal lines and power lines connected to the pixels PXL. For example, the circuit layer PCL may include scan lines SL, control lines SSL, data lines DL, sensing lines SENL, and/or first and second power lines PL1 and PL2, which are connected to the pixels PXL. FIG. 22 illustrates, as an example of wires that may be disposed on the circuit layer PCL, wires LI positioned on the same layer (for example, a first conductive layer) as the bottom metal layer BML. Each wire LI may be one of the signal lines and the power lines connected to the pixels PXL. In the embodiment, at least one signal line and/or power line may be disposed in the other layer of the circuit layer PCL.

In addition to this, the circuit layer PCL may include a plurality of insulating layers. For example, the circuit layer PCL may include a buffer layer BFL, a gate insulating layer GI, an interlayer insulating layer ILD, and/or a passivation layer PSV, sequentially disposed on one surface of the base layer BSL

The circuit layer PCL may include a first conductive layer that is disposed on the base layer BSL and includes the bottom metal layer BML of the first transistor M1. For example, the first conductive layer may be disposed between the base layer BSL and the buffer layer BFL, and may include the bottom metal layer BML of the first transistor M1 provided in each pixel circuit PXC. The bottom metal layer BML of the first transistor M1 may overlap a gate electrode GE and a semiconductor pattern SCP of the first transistor M1.

In addition, the first conductive layer may further include at least one wire LI. For example, the first conductive layer may include at least some wires LI of wires extending in the second direction DR2 in the display area DA. For example, the first conductive layer may include the sensing lines SENL and the data lines DL, and the first power line PL1 (or a first sub power line in the second direction configuring a mesh-type of first power line PL1) and/or the second power line PL2 (or a second sub power line in the second direction configuring a mesh-type of second power line PL2), which are connected to the pixels PXL.

The buffer layer BFL may be disposed on one surface of the base layer BSL including the first conductive layer. The buffer layer BFL may prevent impurities from diffusing into each circuit element.

A semiconductor layer may be disposed on the buffer layer BFL. The semiconductor layer may include the semiconductor pattern SCP of each transistor M. The semiconductor pattern SCP may include a channel area overlapping a gate electrode GE of the corresponding transistor M, and first and second conductive areas (for example, source and drain areas) disposed at both sides of the channel area. The semiconductor pattern SCP may be a semiconductor pattern made of polysilicon, amorphous silicon, or an oxide semiconductor.

The gate insulating layer GI may be disposed on the semiconductor layer. In addition, a second conductive layer may be disposed on the gate insulating layer GI.

The second conductive layer may include the gate electrode GE of each transistor M. In addition, the second conductive layer may further include one electrode and/or a bridge pattern of the capacitor Cst provided in the pixel circuit PXC. Additionally, when at least one power line and/or signal line disposed in the display area DA is configured of multiple layers, the second conductive layer may further include at least one conductive pattern configuring the at least one power line and/or signal line.

The interlayer insulating layer ILD may be disposed on the second conductive layer. In addition, a third conductive layer may be disposed on the interlayer insulating layer ILD.

The third conductive layer may include a source electrode SE and a drain electrode DE of each transistor M. The source electrode SE may be connected to one area (for example, a source area) of the semiconductor pattern SCP included in the corresponding transistor M through at least one contact hole CH, and the drain electrode DE may be connected to the other area (for example, a drain area) of the semiconductor pattern SCP included in the corresponding transistor M through at least one other contact hole CH. In addition, the third conductive layer may further include the other electrode of the capacitor Cst, predetermined wires, and/or a bridge pattern, provided in the pixel circuit PXC. For example, the third conductive layer may include at least some wires of wires extending in the first direction DR1 in the display area DA. For example, the third conductive layer may include the scan lines SL, the control lines SSL, the first power line PL1 (or a first sub power line in the first direction configuring a mesh-type of first power line PL1), and/or the second power line PL2 (or a second sub power line in the first direction configuring a mesh-type of second power line PL2), which are connected to pixels (PXL). Additionally, when at least one power line and/or signal line disposed in the display area DA is configured of multiple layers, the third conductive layer may further include at least one conductive pattern configuring the at least one power line and/or signal line.

Each of the conductive pattern, the electrode, and/or the wire configuring the first to third conductive layers may have conductivity by including at least one conductive material, but the configuration material is not particularly limited. For example, each of the conductive pattern, the electrode, and/or the wire configuring the first to third conductive layers may include one or more of molybdenum (Mo), aluminium (Al), platinum (Pt), palladium (Pd), silver (Ag), magnesium (Mg), gold (Au), nickel (Ni), neodymium (Nd), iridium (Ir), chromium (Cr), titanium (Ti), tantalum (Ta), tungsten (W), and copper (Cu), and in addition to this, it may include various types of conductive materials.

The passivation layer PSV may be disposed on the third conductive layer. Each of the buffer layer BFL, the gate insulating layer GI, the interlayer insulating layer ILD and the passivation layer PSV may be formed as a single layer or multilayer, and may include at least one inorganic insulating material and/or organic insulating material. In the embodiment, each of the buffer layer BFL, the gate insulating layer GI, and the interlayer insulating layer ILD may include various types of inorganic insulating materials such as a silicon nitride (SiNₓ), a silicon oxide (SiOₓ), or a silicon oxynitride (SiOₓN_{y}). In the embodiment, the passivation layer PSV may include at least one organic insulating layer including at least one organic insulating material. In the embodiment, the passivation layer PSV may be entirely disposed in at least the display area DA, and may planarize the surface of the circuit layer PCL.

The display layer DPL may be disposed on the passivation layer PSV.

The display layer DPL may include the light emitting part EMU of each pixel PXL. For example, the display layer DPL may include alignment electrodes ALE, at least one light emitting element LD, and pixel electrodes ELT, which are disposed in the light emitting area EA of each pixel PXL. In the embodiment, each light emitting part EMU may include a plurality of light emitting elements LD.

In addition, the display layer DPL may further include insulating patterns and/or insulating layers sequentially disposed on one surface of the base layer BSL on which the circuit layer PCL is formed. For example, the display layer DPL may include bank patterns BNP, a first insulating layer INS1, a first bank BNK1, a second insulating layer INS2, a third insulating layer INS3, a second bank BNK2, and/or a fourth insulating layer INS4. In addition, the display layer DPL may optionally further include a light converting layer CCL.

The bank patterns BNP may be disposed on the passivation layer PSV. The bank patterns BNP may be disposed under the alignment electrodes ALE so as to overlap a portion of each of the alignment electrodes ALE.

The alignment electrodes ALE may protrude in an upper direction (for example, the third direction DR3) of the pixel PXL around the light emitting elements LD by the bank patterns BNP. The bank patterns BNP and the alignment electrodes ALE thereon may form a reflective protruding pattern around the light emitting elements LD. Accordingly, the light efficiency of the pixel PXL may be improved.

The bank patterns BNP may be a single-layered or multi-layered insulating patterns including an inorganic insulating material and/or an organic insulating material. The alignment electrodes ALE may be disposed on the bank patterns BNP.

The alignment electrodes ALE may include at least one conductive material. For example, each of the alignment electrodes ALE may include at least one metal of various metal materials including silver (Ag), magnesium (Mg), aluminium (Al), platinum (Pt), palladium (Pd), gold (Au), nickel (Ni), neodymium (Nd), iridium (Ir), chromium (Cr), titanium (Ti), molybdenum (Mo), and copper (Cu), or an alloy including the same; a conductive oxide such as an indium tin oxide (ITO), an indium zinc oxide (IZO), an indium tin zinc Oxide (ITZO), a zinc oxide (ZnO), an aluminium doped zinc oxide (AZO), a gallium doped zinc oxide (GZO), a zinc tin oxide (ZTO), a gallium tin oxide (GTO), and a fluorine doped tin oxide (FTO); and at least one conductive material among conductive polymers such as PEDOT, but are not limited thereto. For example, the alignment electrodes ALE may include other conductive materials in addition to a carbon nanotube or graphene. That is, the alignment electrodes ALE may have conductivity by including at least one of various conductive materials. In addition, the alignment electrodes ALE may include conductive materials that are the same as or different from each other.

Each of the alignment electrodes ALE may be configured of a single layer or multilayer. As an example, each alignment electrode ALE may include a reflective electrode layer including a reflective conductive material (for example, metal), and may be configured as a single-layered or multi-layered electrode.

The first insulating layer INS1 may be disposed on the alignment electrodes ALE. In the embodiment, the first insulating layer INS1 may include a contact hole for connecting at least one of the alignment electrodes ALE to one pixel electrode ELT. For example, the first insulating layer INS1 may include contact holes for configuring the fourth and fifth contact portions CNT4 and CNT5 of FIG. 21.

The first insulating layer INS1 may be formed as a single layer or multilayer, and may include an inorganic insulating material and/or an organic insulating material. In the embodiment, the first insulating layer INS1 may include at least one type of inorganic insulating material in addition to a silicon nitride (SiNₓ), a silicon oxide (SiOₓ), or a silicon oxynitride (SiOₓN_{y}).

As the alignment electrodes ALE are covered by the first insulating layer INS1, it is possible to prevent the alignment electrodes ALE from being damaged in a subsequent process. In addition, it is possible to prevent the alignment electrodes ALE and the light emitting elements LD from being improperly connected to cause a short defect.

The first bank BNK1 may be disposed in the display area DA in which the alignment electrodes ALE and the first insulating layer INS1 are formed. The first bank BNK1 may be formed in the non-light emitting area NEA to surround the light emitting area EA of each pixel PXL.

The light emitting elements LD may be supplied to each light emitting area EA surrounded by the first bank BNK1. The light emitting elements LD may be aligned between the alignment electrodes ALE by alignment signals applied to the alignment electrodes ALE (or, the alignment lines before being separated into the alignment electrodes ALE of each pixel PXL). For example, when it is assumed that the pixel PXL includes the first alignment electrode ALE1 positioned in a center and the second and third alignment electrodes ALE2 and ALE3 positioned at both sides of the first alignment electrode ALE1, at least one first light emitting element LD1 may be aligned between the first alignment electrode ALE1 and the second alignment electrode ALE2, and at least one second light emitting element LD2 may be aligned between the first alignment electrode ALE1 and the third alignment electrode ALE3.

The second insulating layer INS2 may be disposed on one portion of the light emitting elements LD. In the embodiment, the second insulating layer INS2 may be locally disposed on one portion including a central portion of the light emitting elements LD so as to expose the first and second end portions EP1 and EP2 of the light emitting elements LD aligned in the light emitting area EA of the corresponding pixel PXL. In another embodiment, the second insulating layer INS2 may be entirely formed in the display area DA including a plurality of pixel areas, and may include contact holes exposing the first end portion EP1 and the second end portion EP2 of each of the light emitting elements LD. When the second insulating layer INS2 is formed on the light emitting elements LD, the light emitting elements LD may be stably fixed.

The second insulating layer INS2 may be formed as a single layer or multilayer, and may include at least one inorganic insulating material and/or organic insulating material. For example, the second insulating layer INS2 may include a silicon nitride (SiNₓ), a silicon oxide (SiOₓ), a silicon oxynitride (SiOₓN_{y}), an aluminium oxide (AlₓO_{y}), or a photo resist material, and various types of organic and/or inorganic insulating materials.

Different pixel electrodes ELT may be disposed and/or formed on both end portions of the light emitting elements LD not covered by the second insulating layer INS2, for example, on the first and second end portions EP1 and EP2. For example, the first pixel electrode ELT1 may be disposed on the first end portion EP1 of the first light emitting element LD1, and a portion of the third pixel electrode ELT3 may be disposed on the second end portion EP2 of the first light emitting element LD1. The other portion of the third pixel electrode ELT3 may be disposed on the first end portion EP1 of the second light emitting element LD2, and the second pixel electrode ELT2 may be disposed on the second end portion EP2 of the second light emitting element LD2.

In the embodiment, the first pixel electrode ELT1 may be electrically connected to the first alignment electrode ALE1 through at least one contact portion (for example, the fourth contact portion CNT4 of FIG. 21). In the embodiment, the second pixel electrode ELT2 may be electrically connected to the third alignment electrode ALE3 through at least one contact portion (for example, the fifth contact portion CNT5 of FIG. 21). The third pixel electrode ELT3 may electrically connect at least one first light emitting element LD1 and at least one second light emitting element LD2 to each other.

In the embodiment, the first alignment electrode ALE1 of each pixel PXL may be electrically connected to the first transistor M1 of the corresponding pixel PXL through at least one contact portion (for example, the first contact portion CNT1 of FIG. 21). Similarly, the second and third alignment electrodes ALE2 and ALE3 may be electrically connected to the second power line PL2 through at least one contact portion (for example, the second contact portion CNT2 and the third contact portion CNT3 of FIG. 21), respectively.

The first pixel electrode ELT1 may be disposed at an upper portion of the first alignment electrode ALE1 to overlap a portion of the first alignment electrode ALE1, and the second pixel electrode ELT2 may be disposed at an upper portion of the third alignment electrode ALE3 to overlap a portion of the third alignment electrode ALE3. The third pixel electrode ELT3 may be disposed on upper portions of the first alignment electrode ALE1 and the second alignment electrode ALE2 to overlap another portion of the first alignment electrode ALE1 and the second alignment electrode ALE2.

In the embodiment, the first pixel electrode ELT1 may be electrically connected to the first end portion EP1 of the first light emitting element LD1, and the second pixel electrode ELT2 may be electrically connected to the second end portion EP2 of the second light emitting element LD2. The third pixel electrode ELT3 may be electrically connected to the second end portion EP2 of the first light emitting element LD1 and the first end portion EP1 of the second light emitting element LD2.

The first pixel electrode ELT1, the second pixel electrode ELT2, and/or the third pixel electrode ELT3 may be formed on the same layer or different layers. In the embodiment, the first and second pixel electrodes ELT1 and ELT2 may be formed on the same layer, and the third pixel electrode ELT3 may be formed on a different layer from the first and second pixel electrodes ELT1 and ELT2. For example, the first and second pixel electrodes ELT1 and ELT2, and the third pixel electrode ELT3 may be disposed on different layers with the third insulating layer INS3 interposed therebetween. In another embodiment, all of the first to third electrodes ELT1 to ELT3 may be formed on the same layer. In this case, the pixel PXL may not include the third insulating layer INS3. The mutual position and/or formation order of the pixel electrodes ELT may be variously changed according to embodiments.

Meanwhile, as in the embodiment of FIG. 19, when each pixel PXL includes the light emitting part EMU having a parallel structure or each pixel PXL includes a single light emitting element LD, the pixel PXL may not include the third pixel electrode ELT3. In this case, the first pixel electrode ELT1 may be disposed on the first end portions EP1 of the light emitting elements LD, and the second pixel electrode ELT2 may be disposed on the second end portions EP2 of the light emitting elements LD.

The pixel electrodes ELT may include at least one conductive material. In the embodiment, the pixel electrodes ELT may include a transparent conductive material to allow light emitted from the light emitting elements LD to pass therethrough.

In the embodiment, the display device DD may include the light converting layer CCL disposed on the light emitting part EMU of each pixel PXL. For example, the light converting layer CCL may be provided in each light emitting area EA to be positioned at an upper portion of the light emitting elements LD of each pixel PXL.

In addition, the display device DD may further include the second bank BNK2 disposed in the non-light emitting area NEA to overlap the first bank BNK1. The second bank BNK2 may define (or partition) each light emitting area EA in which the light converting layer CCL is to be formed. In the embodiment, the second bank BNK2 may be integrated with the first bank BNK1.

The second bank BNK2 may include a light blocking and/or reflective material including a black matrix material. The second bank BNK2 may include the same material as or different material from the first bank BNK1.

The light converting layer CCL may include at least one of wavelength converting particles (or color converting particles) for converting the wavelength and/or color of light emitted from the light emitting elements LD, and light scattering particles SCT for increasing light output efficiency of the pixel PXL by scattering light emitted from the light emitting elements LD. For example, each light converting layer CCL may be disposed on each light emitting part EMU. Each light converting layer CCL may include the wavelength converting particles such as at least one type of quantum dots QD (for example, red, green, and/or blue quantum dots), and/or the light scattering particles SCT.

For example, in the case that one pixel PXL is set as a red (or green) pixel and blue light emitting elements LD are provided to the light emitting part EMU of the pixel PXL, the light converting layer CCL including red (or green) quantum dots QD for converting blue light into red (or green) light may be disposed on the light emitting part EMU of the pixel PXL. In addition, the light converting layer CCL may further include the light scattering particles SCT.

The fourth insulating layer INS4 may be formed on one surface of the base layer BSL including the light emitting parts EMU and/or the light converting layers CCL of the pixels PXL.

In the embodiment, the fourth insulating layer INS4 may include at least one organic insulating layer. The fourth insulating layer INS4 may be entirely disposed in at least the display area DA, and may substantially planarize the surface of the display layer DPL. In addition, the fourth insulating layer INS4 may protect the light emitting parts EMU and/or the light converting layers CCL of the pixels PXL.

The color filter layer CFL may be disposed on the fourth insulating layer INS4.

The color filter layer CFL may include color filters CF corresponding to the color of the pixels PXL. For example, the color filter layer CFL may include a first color filter CF1 disposed in the light emitting area EA of the first color pixel PXL1, a second color filter CF2 disposed in the light emitting area EA of the second color pixel PXL2, and a third color filter CF3 disposed in the light emitting area EA of the third color pixel PXL3. Each color filter CF may be provided on the fourth insulating layer INS4 to overlap the light emitting part EMU of the corresponding pixel PXL.

In the embodiment, the first, second, and third color filters CF1, CF2, and CF3 may be disposed to overlap each other in the non-light emitting area NEA. In another embodiment, the first, second, and third color filters CF1, CF2, and CF3 are formed separately from each other on the light emitting area EA of each pixel PXL, and a separate light blocking pattern may be disposed between the first, second, and third color filters CF1, CF2, and CF3.

The encapsulation layer ENC may be disposed on the color filter layer CFL. The encapsulation layer ENC may include a fifth insulating layer INS5. In the embodiment, the fifth insulating layer INS5 may include at least one organic insulating layer including at least one organic insulating material, and may be configured as a single layer or multilayer. The fifth insulating layer INS5 may be entirely formed in at least the display area DA to cover the circuit layer PCL, the display layer DPL, and/or the color filter layer CFL, and may planarize the surface of the display device DD.

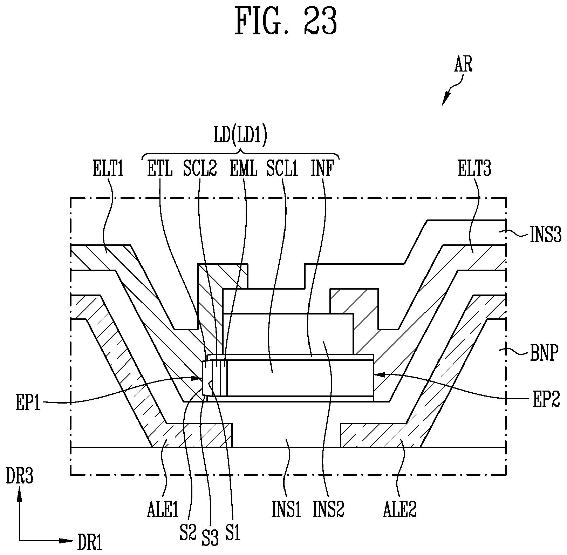

FIG. 23 illustrates an enlarged cross-sectional view of one area of the pixel PXL shown in FIG. 22. For example, FIG. 23 illustrates an enlarged cross-sectional view of one area (for example, an AR area of FIG. 22) of the pixel PXL based on the first light emitting element LD1. In the embodiment, the light emitting elements LD included in the pixels PXL may be light emitting elements (LD) of substantially the same or similar type and/or structure. For example, the second light emitting element LD2 may be a light emitting element LD having the same type and/or structure as that of the first light emitting element LD1.

FIG. 23 illustrates an embodiment in which the pixel PXL of FIG. 22 includes the light emitting element LD according to the embodiment of FIG. 1 and FIG. 2, but the present invention is not limited thereto. For example, the pixel PXL may include a light emitting element LD according to one of the embodiments of figure 3 to figure 7, or light emitting elements LD having a shape and/or structure to which at least two of the embodiments of figure 2 to figure 7 are compositely applied. In describing the embodiment of FIG. 23, a detailed description of a configuration similar to or the same as that of the above-described embodiments will be omitted.

Referring to FIG. 1 to FIG. 23, each light emitting element LD included in the pixel PXL may include the first semiconductor layer SCL1, the emission layer (EML), the second semiconductor layer SCL2, and the electrode layer ETL, which are sequentially disposed from the second end portion EP2 to the first end portion EP1. In addition, each light emitting element LD may include the insulating film INF surrounding the side surfaces of the first semiconductor layer SCL1, the emission layer EML, the second semiconductor layer SCL2, and the electrode layer ETL.

The electrode layer ETL may include the first surface S1 adjacent to the second semiconductor layer SCL2 (for example, in contact with the second semiconductor layer SCL2), the second surface S2 facing the first surface S1 and having a width and/or area smaller than the first surface S1, and the side surface S3 connecting the first surface S1 and the second surface S2. The side surface S3 of the electrode layer ETL may have a slope corresponding to an angle (θ) of about 75° to 90° with respect to the first surface S1 of the electrode layer ETL.

The insulating film INF may completely surround the side surfaces of the emission layer EML and the second semiconductor layer SCL2, and may at least partially surround the side surfaces of the electrode layer ETL and the first semiconductor layer SCL1. The insulating film INF may partially expose the electrode layer ETL and the first semiconductor layer SCL1 at the first end portion EP1 and the second end portion EP2 of the light emitting element LD, respectively.

The electrode layer ETL may be electrically connected to the first pixel electrode ELT1. For example, the electrode layer ETL may directly contact the first pixel electrode ELT1 at the first end portion EP1 of the light emitting element LD in which the second insulating layer INS2 is not provided, and may be electrically connected to the first pixel electrode ELT1.

In the embodiment, the electrode layer ETL may directly contact the second semiconductor layer SCL2 on the first surface S1. The side surface S3 of the electrode layer ETL may be surrounded by the insulating film INF at a portion corresponding to at least the first surface S1. For example, the insulating film INF may surround a portion of the side surface S3 of the electrode layer ETL positioned around the first surface S1 of the electrode layer ETL, and may expose the second surface S2 of the electrode layer ETL and the other portion of the side surface S3 of the electrode layer ETL positioned around the second surface S2.

The first semiconductor layer SCL1 may be electrically connected to the third pixel electrode ELT3 (and/or second pixel electrode ELT2). For example, the first semiconductor layer SCL1 may directly contact the third pixel electrode ELT3 at the second end portion EP2 of the light emitting element LD in which the second insulating layer INS2 is not provided, and may be electrically connected to the third pixel electrode ELT3.

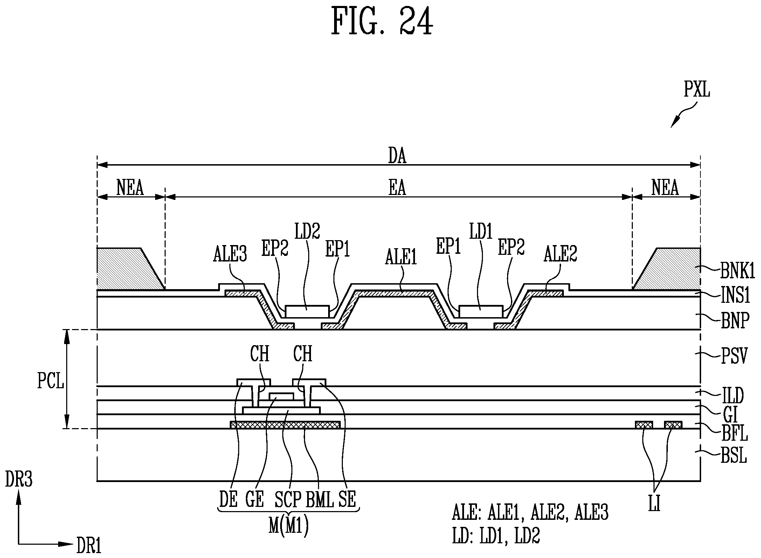

FIG. 24 to FIG. 26 illustrate cross-sectional views of a manufacturing method of a pixel PXL according to an embodiment of the present invention. For example, FIG. 24 to FIG. 26 sequentially illustrate a method of disposing at least one light emitting element LD in each pixel PXL and a method of forming the second insulating layer INS2 on the light emitting element LD, during the pixel process for manufacturing the pixel PXL according to the embodiment of FIG. 22 and FIG. 23.

Referring to FIG. 1 to FIG. 24, between a pair of alignment electrodes ALE covered by the first insulating layer INS1 (for example, between the first and second alignment electrodes ALE1 and ALE2 and/or the first and third alignment electrodes ALE1 and ALE3), at least one light emitting element LD may be aligned and/or disposed. In the embodiment, a plurality of light emitting elements LD may be supplied to each light emitting area EA defined by the first bank BNK1 by utilizing an inkjet method or a slit coating method. In addition, by applying respective alignment signals to the alignment electrodes ALE, the light emitting elements LD may be aligned between the alignment electrodes ALE.

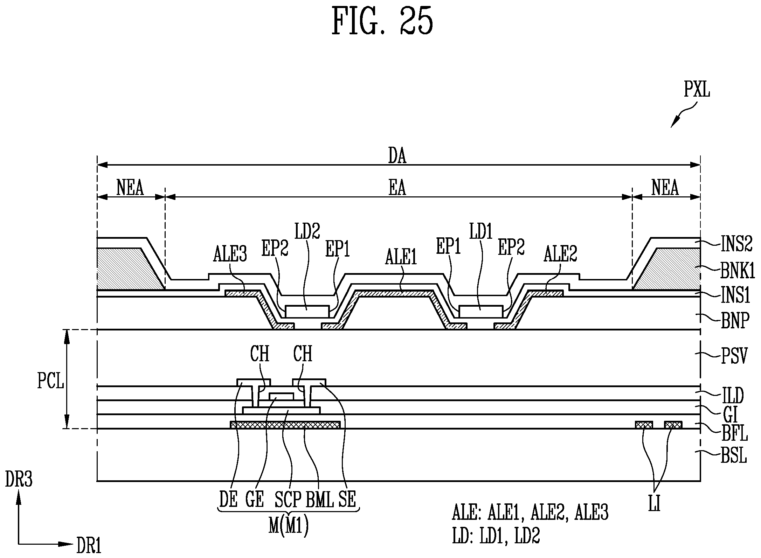

Referring to FIG. 25, the second insulating layer INS2 may be formed in the display area DA in which the light emitting elements LD are aligned in the light emitting area EA of each pixel PXL. The second insulating layer INS2 may be primarily entirely formed in the display area DA.

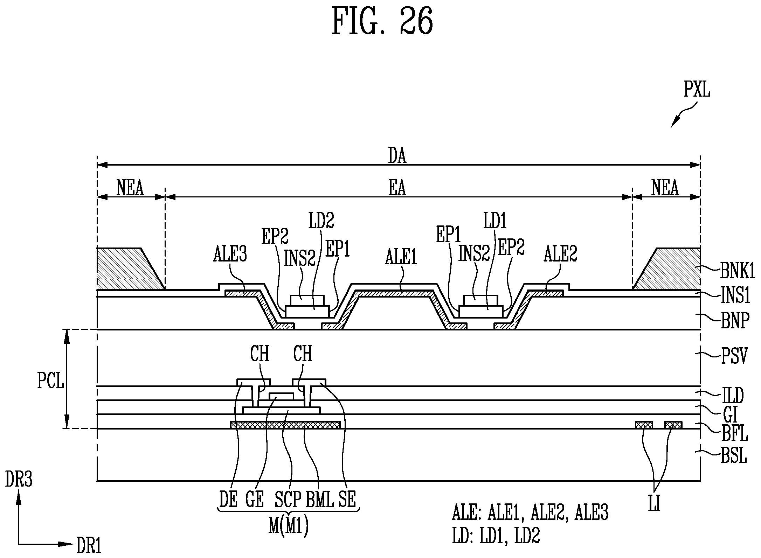

Referring to FIG. 26, the second insulating layer INS2 may be etched to expose the first end portion EP1 and the second end portion EP2 of each of the light emitting elements LD. For example, the second insulating layer INS2 may be patterned so that the electrode layer ETL and the first semiconductor layer SCL1 are respectively exposed at the first end portion EP1 and the second end portion EP2 of each of the light emitting elements LD. Thereafter, by forming respective pixel electrodes ELT on the first end portion EP1 and the second end portion EP2 of each of the light emitting elements LD in a subsequent process, the light emitting elements LD may be electrically connected between at least a pair of pixel electrodes ELT.

In the embodiment, in the process of etching the second insulating layer INS2, in the first and second end portions EP1 and EP2 of the light emitting element LD and/or the peripheral area thereof, the insulating film INF may be etched by a predetermined thickness. However, in the present invention as in the above-described embodiments, by controlling the side slope of the electrode layer ETL, even in the area corresponding to the bonding surface of the second semiconductor layer SCL2 and the electrode layer ETL (for example, an area corresponding to the periphery of the first surface S1 of the electrode layer ETL), the insulating film INF may be formed with a thickness greater than or equal to a thickness corresponding to a process margin (for example, overetching margin) in a subsequent process. Accordingly, even after the etching of the second insulating layer INS2 is completed, the second insulating layer SCL2 may be completely surrounded by the insulating film INF.

Therefore, according to the embodiments of the present invention, it is possible to prevent a short circuit defect (for example, a short circuit defect that may occur through the second semiconductor layer SCL2) due to exposure of the second semiconductor layer SCL2, and it is possible to stably connect the light emitting element LD between the pixel electrodes ELT. Accordingly, it is possible to prevent a defect of the pixel PXL (for example, a dark spot defect) due to a short circuit defect through the light emitting element LD.

The technical idea of the present invention has been specifically described according to the preferred embodiments, but it should be noted that the foregoing embodiments are provided only for illustration while not limiting the present invention. In addition, it will be understood by those skilled in the art that various changes in form and details may be made therein without departing from the scope of the present invention as defined by the claims.

## Claims

1. A light emitting element (LD), comprising:
a first semiconductor layer (SCL1);
an emission layer (EML) disposed on the first semiconductor layer (SCL1);
a second semiconductor layer (SCL2) disposed on the emission layer (EML);
an electrode layer (ETL) disposed on the second semiconductor layer (SCL2); and
an insulating film (INF) that surrounds side surfaces of the first semiconductor layer (SCL1), the emission layer (EML), and the second semiconductor layer (SCL2) and surrounds a portion of the electrode layer (ETL) at an end portion (EP1) of the light emitting element (LD) on which the electrode layer (ETL) is disposed,
wherein the electrode layer (ETL) includes:
a first surface **(S1)** adjacent to the second semiconductor layer (SCL2);
a second surface (S2) facing the first surface (S1) and having a width smaller than that of the first surface (S1); and
a side surface (S3) that connects the first surface (S1) and the second surface (S2) and has a slope corresponding to an angle of 75° to 90° with respect to the first surface (S1) of the electrode layer (ETL),
wherein a width of a lateral cross-section of the second semiconductor layer (SCL2) and a width of a lateral cross-section of the emission layer (EML) are constant and the same as a width of a lateral cross-section of the first surface (S1) of the electrode layer (ETL), and
wherein a width of a lateral cross-section of the first semiconductor layer (SCL1) at the surface adjacent to the emission layer (EML) is the same as the width of the lateral cross-section of the emission layer (EML).

2. The light emitting element of claim 1, wherein
the insulating film completely surrounds the side surfaces of the emission layer and the second semiconductor layer.

3. The light emitting element of claim 1 or claim 2, wherein
the electrode layer directly electrically contacts the second semiconductor layer on the first surface.

4. The light emitting element of claim 3, wherein
the insulating film surrounds a portion of the side surface of the electrode layer disposed around the first surface of the electrode layer, and exposes the second surface of the electrode layer and the remaining portion of the side surface of the electrode layer.

5. The light emitting element of any one of claims 1 to 4, wherein
the insulating film exposes a lower surface of the first semiconductor layer.

6. The light emitting element of any one of claims 1 to 5, wherein
the insulating film has a uniform thickness at the end portion of the light emitting element.

7. The light emitting element of any one of claims 1 to 6, wherein:
(i) the insulating film has a surface profile corresponding to a shape of each side surface of the first semiconductor layer, the emission layer, and the second semiconductor layer in a portion surrounding the first semiconductor layer, the emission layer, and the second semiconductor layer; and/or
(ii) the insulating film has a surface profile corresponding to a shape of the side surface of the electrode layer at the end portion of the light emitting element.

8. The light emitting element of any one of claims 1 to 5, wherein
the insulating film has a thickness that is gradually changed at the end portion of the light emitting element, optionally wherein
the insulating film has a thickness that increases as it approaches the emission layer at the end portion of the light emitting element.

9. The light emitting element of any one of claims 1 to 5, wherein
the first semiconductor layer includes a first portion adjacent to the emission layer and a second portion excluding the first portion, and a width of the first portion is greater than a width of the second portion, optionally wherein
a thickness of a portion surrounding the second portion of the first semiconductor layer is greater than a thickness of a portion surrounding the first portion of the first semiconductor layer in the insulating film.

10. The light emitting element of any one of claims 1 to 9, wherein
the insulating film has a thickness of about 10 nm or more at a portion corresponding to the first surface of the electrode layer.

11. A display device comprising:
a pixel including a first electrode, a second electrode, and a light emitting element according to claim 1,
wherein the light emitting element includes a first end portion electrically connected to the first electrode, and a second end portion electrically connected to the second electrode, and
the first semiconductor layer, the emission layer, the second semiconductor layer, and the electrode layer are sequentially disposed in a direction from the second end portion to the first end portion of the light emitting element.

12. The display device of claim 11, wherein:
(i) the insulating film completely surrounds the side surfaces of the emission layer and the second semiconductor layer; and/or
(ii) the electrode layer directly electrically contacts the second semiconductor layer on the first surface, and
the insulating film surrounds a portion of the side surface of the electrode layer disposed around the first surface of the electrode layer, and exposes the second surface of the electrode layer and the remaining portion of the side surface of the electrode layer.

13. A manufacturing method of a light emitting element (LD), comprising:
sequentially forming a first semiconductor layer (SCL1), an emission layer (EML), a second semiconductor layer (SCL2), and an electrode layer (ETL) on a substrate (SB);
sequentially forming a mask layer (MK) and an etching pattern (PT) on the electrode layer (ETL);
patterning a stacked body (LES) including the first semiconductor layer, layer (SCL1), the emission layer (EML), the second semiconductor layer (SCL2), and the electrode layer (ETL) in a rod shape by an etching process using the mask layer (MK) and the etching pattern (PT);
forming an insulating film (INF) on side surfaces of the first semiconductor layer (SCL1), the emission layer (EML), the second semiconductor layer (SCL2), and the electrode layer (ETL); and
separating the light emitting element (LD) from the substrate (SB),
wherein in the patterning of the stacked body (LES) in the rod shape, the electrode layer (ETL) is etched so that a side surface of the electrode layer (ETL) has a slope corresponding to an angle of 75° to 90° with respect to the substrate (SB),
wherein a width of a lateral cross-section of the second semiconductor layer (SCL2) and a width of a lateral cross-section of the emission layer (EML) are constant and the same as a width of a lateral cross-section of the first surface of the electrode layer (ETL), and
wherein a width of a lateral cross-section of the first semiconductor layer (SCL1) at a surface adjacent to the emission layer (EML) is the same as the width of the lateral cross-section of the emission layer (EML).

14. The manufacturing method of the light emitting element of claim 13, wherein
the mask layer is formed with a thickness of 2 µm or more, optionally wherein
the forming of the mask layer includes:
forming a first mask layer with a thickness of 2 µm or more on the electrode layer; and
forming a second mask layer with a thickness of 160 nm or more on the first mask layer by using a material different from a material of the first mask layer.

15. The manufacturing method of the light emitting element of claim 13 or claim 14, wherein
the forming of the insulating film includes:
entirely forming the insulating film on one surface of the substrate including the stacked body; and
etching the insulating film so that an upper surface of the electrode layer is exposed.

## Patentansprüche

1. Lichtemittierendes Element (LD), umfassend:
eine erste Halbleiterschicht (SCL1);
eine Emissionsschicht (EML), welche auf der ersten Halbleiterschicht (SCL1) angeordnet ist;
eine zweite Halbleiterschicht (SCL2), welche auf der Emissionsschicht (EML) angeordnet ist;
eine Elektrodenschicht (ETL), welche auf der zweiten Halbleiterschicht (SCL2) angeordnet ist; und
eine Isolierhaut (INF), welche seitliche Oberflächen der ersten Halbleiterschicht (SCL1), der Emissionsschicht (EML) und der zweiten Halbleiterschicht (SCL2) umgibt und einen Abschnitt der Elektrodenschicht (ETL) an einem Endabschnitt (EP1) des lichtemittierenden Elements (LD) umgibt, auf welchem die Elektrodenschicht (ETL) angeordnet ist.
wobei die Elektrodenschicht (ETL) beinhaltet:
eine an die zweite Halbleiterschicht (SCL2) angrenzende erste Oberfläche (S1);
eine zweite Oberfläche (S2), welche der ersten Oberfläche (S1) zugewandt ist und eine Breite aufweist, welche geringer als jene der ersten Oberfläche (S1) ist; und
eine seitliche Oberfläche (S3), welche die erste Oberfläche (S1) und die zweite Oberfläche (S2) verbindet und eine Neigung aufweist, welche einem Winkel von 75° bis 90° in Bezug auf die erste Oberfläche (S1) der Elektrodenschicht (ETL) entspricht,
wobei eine Breite eines lateralen Querschnitts der zweiten Halbleiterschicht (SCL2) und eine Breite eines lateralen Querschnitts der Emissionsschicht (EML) konstant und gleich einer Breite eines lateralen Querschnitts der ersten Oberfläche (S1) der Elektrodenschicht (ETL) sind, und
wobei eine Breite eines lateralen Querschnitts der ersten Halbleiterschicht (SCL1) an der an die Emissionsschicht (EML) angrenzenden Oberfläche gleich der Breite des lateralen Querschnitts der Emissionsschicht (EML) ist.

2. Lichtemittierendes Element nach Anspruch 1, wobei
die Isolierhaut die seitlichen Oberflächen der Emissionsschicht und der zweiten Halbleiterschicht vollständig umgibt.

3. Lichtemittierendes Element nach Anspruch 1 oder Anspruch 2, wobei
die Elektrodenschicht in direktem elektrischem Kontakt mit der zweiten Halbleiterschicht auf der ersten Oberfläche steht.

4. Lichtemittierendes Element nach Anspruch 3, wobei
die Isolierhaut einen Abschnitt der seitlichen Oberfläche der rund um die erste Oberfläche der Elektrodenschicht angeordneten Elektrodenschicht umgibt, und die zweite Oberfläche der Elektrodenschicht sowie den verbleibenden Abschnitt der seitlichen Oberfläche der Elektrodenschicht freilegt.

5. Lichtemittierendes Element nach einem der Ansprüche 1 bis 4, wobei
die Isolierhaut eine tiefer liegende Oberfläche der ersten Halbleiterschicht freigelegt.

6. Lichtemittierendes Element nach einem der Ansprüche 1 bis 5, wobei
die Isolierhaut am Endabschnitt des lichtemittierenden Elements eine einheitliche Dicke aufweist.

7. Lichtemittierendes Element nach einem der Ansprüche 1 bis 6, wobei:
(i) die Isolierhaut ein Oberflächenprofil aufweist, welches einer Form jeder seitlichen Oberfläche der ersten Halbleiterschicht, der Emissionsschicht und der zweiten Halbleiterschicht in einem Abschnitt entspricht, welcher die erste Halbleiterschicht, die Emissionsschicht und die zweite Halbleiterschicht umgibt; und/oder
(ii) die Isolierhaut ein Oberflächenprofil aufweist, welches der Form der seitlichen Oberfläche der Elektrodenschicht am Endabschnitt des lichtemittierenden Elements entspricht.

8. Lichtemittierendes Element nach einem der Ansprüche 1 bis 5, wobei
die Isolierhaut eine Dicke aufweist, welche am Endabschnitt des lichtemittierenden Elements allmählich geändert wird, optional wobei
die Isolierhaut eine Dicke aufweist, welche zunimmt, wenn sie der Emissionsschicht am Endabschnitt des lichtemittierenden Elements nähert.

9. Lichtemittierendes Element nach einem der Ansprüche 1 bis 5, wobei
die erste Halbleiterschicht einen an die Emissionsschicht angrenzenden ersten Abschnitt, und einen zweiten Abschnitt beinhaltet, welcher den ersten Abschnitt ausschließt, und eine Breite des ersten Abschnitts größer ist als eine Breite des zweiten Abschnitts, optional wobei
eine Dicke eines Abschnitts, welcher den zweiten Abschnitt der ersten Halbleiterschicht umgibt, größer als eine Dicke eines Abschnitts ist, welcher den ersten Abschnitt der ersten Halbleiterschicht in der Isolierhaut umgibt.

10. Lichtemittierendes Element nach einem der Ansprüche 1 bis 9, wobei
die Isolierhaut an einem Abschnitt, welcher der ersten Oberfläche der Elektrodenschicht entspricht, eine Dicke von etwa 10 nm oder mehr aufweist.

11. Anzeigevorrichtung, umfassend:
ein Pixel, welches eine erste Elektrode, eine zweite Elektrode und ein lichtemittierendes Element nach Anspruch 1 beinhaltet,
wobei das lichtemittierende Element einen ersten Endabschnitt, welcher mit der ersten Elektrode elektrisch verbunden ist, und einen zweiten Endabschnitt beinhaltet, welcher mit der zweiten Elektrode elektrisch verbunden ist, und
die erste Halbleiterschicht, die Emissionsschicht, die zweite Halbleiterschicht und die Elektrodenschicht in einer Richtung von dem zweiten Endabschnitt zu dem ersten Endabschnitt des lichtemittierenden Elements sequenziell angeordnet sind.

12. Anzeigevorrichtung nach Anspruch 11, wobei:
(i) die Isolierhaut die seitlichen Oberflächen der Emissionsschicht und der zweiten Halbleiterschicht vollständig umgibt; und/oder
(ii) die Elektrodenschicht in direktem elektrischem Kontakt mit der zweiten Halbleiterschicht auf der ersten Oberfläche steht, und
die Isolierhaut einen Abschnitt der seitlichen Oberfläche der rund um die erste Oberfläche der Elektrodenschicht angeordneten Elektrodenschicht umgibt, und die zweite Oberfläche der Elektrodenschicht sowie den verbleibenden Abschnitt der seitlichen Oberfläche der Elektrodenschicht freilegt.

13. Herstellungsverfahren für ein lichtemittierendes Element (LD), umfassend:
sequenzielles Bilden einer ersten Halbleiterschicht (SCL1), einer Emissionsschicht (EML), einer zweiten Halbleiterschicht (SCL2) und einer Elektrodenschicht (ETL) auf einem Substrat (SB);
sequenzielles Bilden einer Maskenschicht (MK) und eines Ätzmusters (PT) auf der Elektrodenschicht (ETL);
Strukturieren eines gestapelten Körpers (LES), welcher die erste Halbleiterschicht (SCL1), die Emissionsschicht (EML), die zweite Halbleiterschicht (SCL2) und die Elektrodenschicht (ETL) in einer Stabform beinhaltet, durch einen Ätzprozess unter Verwendung der Maskenschicht (MK) und des Ätzmusters (PT);
Bilden einer Isolierhaut (INF) auf den seitlichen Oberflächen der ersten Halbleiterschicht (SCL1), der Emissionsschicht (EML), der zweiten Halbleiterschicht (SCL2) und der Elektrodenschicht (ETL); und
Trennen des lichtemittierenden Elements (LD) von dem Substrat (SB),
wobei beim Strukturieren des gestapelten Körpers (LES) in der Stabform die Elektrodenschicht (ETL) geätzt wird, sodass eine seitliche Oberfläche der Elektrodenschicht (ETL) eine Neigung aufweist, welche einem Winkel von 75° bis 90° in Bezug auf das Substrat (SB) entspricht,
wobei eine Breite eines lateralen Querschnitts der zweiten Halbleiterschicht (SCL2) und eine Breite eines lateralen Querschnitts der Emissionsschicht (EML) konstant und gleich einer Breite eines lateralen Querschnitts der ersten Oberfläche der Elektrodenschicht (ETL) sind, und
wobei eine Breite eines lateralen Querschnitts der ersten Halbleiterschicht (SCL1) an einer an die Emissionsschicht (EML) angrenzenden Oberfläche gleich der Breite des lateralen Querschnitts der Emissionsschicht (EML) ist.

14. Herstellungsverfahren des lichtemittierenden Elements nach Anspruch 13, wobei
die Maskenschicht mit einer Dicke von 2 µm oder mehr gebildet ist, optional wobei
das Bilden der Maskenschicht beinhaltet:
Bilden einer ersten Maskenschicht mit einer Dicke von 2 µm oder mehr auf der ersten Elektrodenschicht; und
Bilden einer zweiten Maskenschicht mit einer Dicke von 160 nm oder mehr auf der ersten Maskenschicht unter Verwendung eines von dem Material der ersten Maskenschicht verschiedenen Materials.

15. Herstellungsverfahren des lichtemittierenden Elements nach Anspruch 13 oder Anspruch 14, wobei
das Bilden der Isolierhaut beinhaltet:
vollständiges Bilden der Isolierhaut auf einer Oberfläche des Substrats, welches den gestapelten Körper beinhaltet; und
Ätzen der Isolierhaut, sodass eine obere Oberfläche der Elektrodenschicht freigelegt wird.

## Revendications

1. Élément électroluminescent (LD) comprenant :
une première couche semi-conductrice (SCL1) ;
une couche d'émission (EML) disposée sur la première couche semi-conductrice (SCL1) ;
une seconde couche semi-conductrice (SCL2) disposée sur la couche d'émission (EML) ;
une couche d'électrode (ETL) disposée sur la seconde couche semi-conductrice (SCL2) ; et
un film isolant (INF) qui entoure les surfaces latérales de la première couche semi-conductrice (SCL1), de la couche d'émission (EML) et de la seconde couche semi-conductrice (SCL2) et entoure une partie de la couche d'électrode (ETL) à une partie d'extrémité (EP1) de l'élément électroluminescent (LD) sur lequel la couche d'électrode (ETL) est disposée,
dans lequel la couche d'électrode (ETL) inclut :
une première surface (S1) adjacente à la seconde couche semi-conductrice (SCL2) ;
une seconde surface (S2) faisant face à la première surface (S1) et présentant une largeur plus petite que celle de la première surface (S1) ; et
une surface latérale (S3) qui relie la première surface (S1) et la seconde surface (S2) et présente une pente correspondant à un angle de 75° à 90° par rapport à la première surface (S1) de la couche d'électrode (ETL),
dans lequel une largeur d'une coupe transversale latérale de la seconde couche semi-conductrice (SCL2) et une largeur d'une coupe transversale latérale de la couche d'émission (EML) sont constantes et identiques à une largeur d'une coupe transversale latérale de la première surface (S1) de la couche d'électrode (ETL), et
dans lequel une largeur d'une coupe transversale latérale de la première couche semi-conductrice (SCL1) au niveau de la surface adjacente à la couche d'émission (EML) est identique à la largeur de la coupe transversale latérale de la couche d'émission (EML).

2. Élément électroluminescent selon la revendication 1, dans lequel
le film isolant entoure complètement les surfaces latérales de la couche d'émission et de la seconde couche semi-conductrice.

3. Élément électroluminescent selon la revendication 1 ou la revendication 2, dans lequel
la couche d'électrode est directement en contact électrique avec la seconde couche semi-conductrice sur la première surface.

4. Élément électroluminescent selon la revendication 3, dans lequel
le film isolant entoure une partie de la surface latérale de la couche d'électrode disposée autour de la première surface de la couche d'électrode, et expose la seconde surface de la couche d'électrode et la partie restante de la surface latérale de la couche d'électrode.

5. Élément électroluminescent selon l'une quelconque des revendications 1 à 4, dans lequel
le film isolant expose une surface inférieure de la première couche semi-conductrice.

6. Élément électroluminescent selon l'une quelconque des revendications 1 à 5, dans lequel
le film isolant présente une épaisseur uniforme à la partie d'extrémité de l'élément électroluminescent.

7. Élément électroluminescent selon l'une quelconque des revendications 1 à 6, dans lequel :
(i) le film isolant présente un profil de surface correspondant à une forme de chaque surface latérale de la première couche semi-conductrice, de la couche d'émission et de la seconde couche semi-conductrice dans une partie entourant la première couche semi-conductrice, la couche d'émission et la seconde couche semi-conductrice ; et/ou
(ii) le film isolant présente un profil de surface correspondant à la forme de la surface latérale de la couche d'électrode à la partie d'extrémité de l'élément électroluminescent.

8. Élément électroluminescent selon l'une quelconque des revendications 1 à 5, dans lequel
le film isolant présente une épaisseur qui varie progressivement à la partie d'extrémité de l'élément électroluminescent, optionnellement dans lequel
le film isolant présente une épaisseur qui augmente au fur et à mesure qu'il se rapproche de la couche d'émission à la partie d'extrémité de l'élément électroluminescent.

9. Élément électroluminescent selon l'une quelconque des revendications 1 à 5, dans lequel
la première couche semi-conductrice inclut une première partie adjacente à la couche d'émission et une seconde partie excluant la première partie, et la largeur de la première partie est plus grande que la largeur de la seconde partie, optionnellement dans lequel
une épaisseur d'une partie entourant la seconde partie de la première couche semi-conductrice est plus grande qu'une épaisseur d'une partie entourant la première partie de la première couche semi-conductrice dans le film isolant.

10. Élément électroluminescent selon l'une quelconque des revendications 1 à 9, dans lequel
le film isolant présente une épaisseur d'environ 10 nm ou plus au niveau d'une partie correspondant à la première surface de la couche d'électrode.

11. Dispositif d'affichage comprenant :
un pixel incluant une première électrode, une seconde électrode, et un élément électroluminescent selon la revendication 1,
dans lequel l'élément électroluminescent inclut une première partie d'extrémité connectée électriquement à la première électrode, et une seconde partie d'extrémité connectée électriquement à la seconde électrode, et
la première couche semi-conductrice, la couche d'émission, la seconde couche semi-conductrice et la couche d'électrode sont disposées de manière séquentielle dans une direction depuis la seconde partie d'extrémité jusqu'à la première partie d'extrémité de l'élément électroluminescent.

12. Dispositif d'affichage selon la revendication 11, dans lequel :
(i) le film isolant entoure complètement les surfaces latérales de la couche d'émission et de la seconde couche semi-conductrice ; et/ou
(ii) la couche d'électrode est directement en contact électrique avec la seconde couche semi-conductrice sur la première surface, et
le film isolant entoure une partie de la surface latérale de la couche d'électrode disposée autour de la première surface de la couche d'électrode, et expose la seconde surface de la couche d'électrode et la partie restante de la surface latérale de la couche d'électrode.

13. Procédé de fabrication d'un élément électroluminescent (LD), comprenant :
la formation séquentielle d'une première couche semi-conductrice (SCL1), d'une couche d'émission (EML), d'une seconde couche semi-conductrice (SCL2) et d'une couche d'électrode (ETL) sur un substrat (SB) ;
la formation séquentielle d'une couche de masque (MK) et d'un motif de gravure (PT) sur la couche d'électrode (ETL) ;
le façonnage d'un corps empilé (LES) incluant la première couche semi-conductrice (SCL1), la couche d'émission (EML), la seconde couche semi-conductrice (SCL2) et la couche d'électrode (ETL) en forme de tige par un processus de gravure utilisant la couche de masque (MK) et le motif de gravure (PT) ;
la formation d'un film isolant (INF) sur les surfaces latérales de la première couche semi-conductrice (SCL1), de la couche d'émission (EML), de la seconde couche semi-conductrice (SCL2) et de la couche d'électrode (ETL) ; et
la séparation de l'élément électroluminescent (LD) du substrat (SB),
dans lequel, lors du façonnage du corps empilé (LES) en forme de tige, la couche d'électrode (ETL) est gravée de façon à ce qu'une surface latérale de la couche d'électrode (ETL) présente une pente correspondant à un angle de 75° à 90° par rapport au substrat (SB),
dans lequel une largeur d'une coupe transversale latérale de la seconde couche semi-conductrice (SCL2) et une largeur d'une coupe transversale latérale de la couche d'émission (EML) sont constantes et identiques à une largeur d'une coupe transversale latérale de la première surface de la couche d'électrode (ETL), et
dans lequel une largeur d'une coupe transversale latérale de la première couche semi-conductrice (SCL1) au niveau d'une surface adjacente à la couche d'émission (EML) est identique à la largeur de la coupe transversale latérale de la couche d'émission (EML).

14. Procédé de fabrication de l'élément électroluminescent selon la revendication 13, dans lequel
la couche de masque est formée avec une épaisseur de 2 µm ou plus, optionnellement dans lequel
la formation de la couche de masque inclut :
la formation d'une première couche de masque avec une épaisseur de 2 µm ou plus sur la couche d'électrode ; et
la formation d'une seconde couche de masque avec une épaisseur de 160 nm ou plus sur la première couche de masque en utilisant un matériau différent d'un matériau de la première couche de masque.

15. Procédé de fabrication de l'élément électroluminescent selon la revendication 13 ou la revendication 14, dans lequel
la formation du film isolant inclut :
la formation entière du film isolant sur une surface du substrat incluant le corps empilé ; et
la gravure du film isolant de façon à ce qu'une surface supérieure de la couche d'électrode soit exposée.
